# EUROPEAN PATENT SPECIFICATION

(11) **EP 3 212 700 B1**
(45) Date of publication and mention of the grant of the patent: **14.08.2019**
(21) Application number: 15790806.2
(22) Date of filing: 30.10.2015
(51) Int. Cl.: C08K 3/34, C09D 123/08, C09D 123/10, C09D 151/06, C09D 153/02, C08K 9/04, H01L 31/048

(54) **PV MODULE WITH FILM LAYER COMPRISING MICRONIZED SILICA GEL**
PHOTOVOLTAISCHE ELEMENTE MIT FILMSCHICHTEN DIE MICRONISIERTES SILICA GEL ENTHALTEN
MODULE PV AVEC UNE COUCHE DE FILM COMPRENANT SILICA GEL MICRONISE

(30) Priority: 30.10.2014 US 201462072576 P
(43) Date of publication of application: 06.09.2017
(73) Proprietor: Dow Global Technologies LLC, Midland, MI 48674 (US)
(72) Inventor: DEPLACE, Fanny, Freeport, TX 77566 (US); NANJUNDIAH, Kumar, Freeport, TX 77566 (US); BONEKAMP, Jeffrey, E., Midland, MI 48674 (US); NAUMOVITZ, John, A., Midland, MI 48674 (US)
(74) Representative: Boult Wade Tennant LLP
(86) International application number: PCT/US2015/058382
(87) International publication number: WO 2016/070087

(56) References cited:
- WO-A1-2011/068597
- WO-A1-2012/087441
- WO-A1-2014/075246
- US-A1- 2005 238 874

## Description

### FIELD

This disclosure relates to encapsulant films having improved shelf life as reflected by an improved glass adhesion and electronic devices, such as photovoltaic modules, containing such encapsulant films.

### BACKGROUND

In the construction of a typical electronic device such as a photovoltaic (PV) module, there is a front light transmitting and receiving layer, usually glass, followed by a front encapsulant film layer, the electronic component (e.g., photovoltaic cells), a rear encapsulant film layer and, finally, a backsheet. In some instances, the rear encapsulant film layer and the backsheet may be a single film with integrated encapsulant and backsheet functionality, or a back encapsulant composite (BEC) film. Encapsulant films offer insulation and environmental protection for electrical components used in the electronic device, such as a photovoltaic cell used in a PV module. Encapsulant films can act as a skin for the electrical component or device or completely enclose the electrical component or device.

Many encapsulant films use silane-grafted polyolefins (Si-g-POs) as a base resin for the film, or, in the case of a multilayer film, as an outer layer of the film. Encapsulant films using Si-g-POs as the base polymer can exhibit blocking on rolls and require an antiblock to decrease sticking. However, not all fillers used as antiblocks have been found to demonstrate compatibility with Si-g-POs. Si-g-POs show greater crosslinking upon melt processing than other polyolefins. Many fillers added to Si-g-PO resins cause accelerated crosslinking in melt processing compared to the Si-g-PO base resin alone. For example, Mitsui JC50 Na-Ca-Al silicate, used in Ampacet 102077 masterbatch, decreases time to crosslink relative to the base Si-g-PO resin, making the antiblock less useful. Higher levels of antiblock also decrease the time to crosslink. A shorter crosslink time results in films with increased gel content after processing which removes the number of bondable grafts available and lowers glass adhesion.

Encapsulant films made of Si-g-PO resins and Si-g-PO resins with antiblock stored in a controlled environment with barrier packaging may also show loss of initial adhesion to glass over time. Such reduced glass adhesion results in a shorter shelf life for the films. Reduced initial glass adhesion is accelerated when stored in environments with higher temperatures and/or higher humidity.

WO 2001/068597 describes the use of calcium oxide as a water scavenger in solar module applications.

WO2014/075246 describes methods of making coating comprising aqueous fluoropolymer latex dispersions, aqueous fluoropolymer coating compositions, coated substrates, and (e.g. backside) films of photovoltaic cells.

US-A-2005/238874 describes multi-layer films that are suitable for packaging and having improved sealing properties.

A need exists for encapsulant films containing a Si-g-PO base resin having improved shelf life *(i.e.,* improved glass adhesion after storage) and which contain an antiblock compatible with the Si-g-PO resin.

### SUMMARY

The present disclosure provides a photovoltaic module. In an embodiment, the photovoltaic module includes a photovoltaic cell, and a layer composed of a film. The film includes a silane-grafted polyolefin (Si-g-PO) resin composition comprising (i) one or more silane grafted polyolefins and (ii) from greater than 0 wt% to less than 5.0 wt% of a micronized silica gel, based on the total weight of the Si-g-PO resin composition. The film has a glass adhesion greater than or equal to 15N/mm after aging the film at 40°C and 0% relative humidity for 60 days as measured in accordance with ASTM F88/88M-09.

The present disclosure provides another photovoltaic module. In an embodiment, the photovoltaic module includes a photovoltaic cell, and a back encapsulant composite (BEC). The BEC includes a top encapsulant layer (B), a bottom layer (A) and a tie layer (C) between the layer (B) and the layer (A). The top encapsulant layer (A) comprises a silane-grafted polyolefin (Si-g-PO) resin composition comprising (i) one or more silane grafted polyolefins and (ii) from greater than 0 wt% to less than 5.0 wt% of a micronized silica gel, based on the total weight of the Si-g-PO resin composition. The BEC has a glass adhesion greater than or equal to 4 N/mm after aging the film at 40°C and 0% relative humidity for 60 days as measured in accordance with ASTM F88/88M-09.

### BRIEF DESCRIPTION OF THE DRAWINGS

FIG.1 is a cross sectional view of photovoltaic module in accordance with an embodiment of the disclosure.
FIG. 2 is a cross sectional view of a photovoltaic module with a back encapsulant composite in accordance with an embodiment of the present disclosure.
FIG. 3 is a photograph showing black streaking on the back of a PV module using commercially-available encapsulant films.
FIG. 4 is a photograph showing no black streaking on the back of a PV module in accordance with an embodiment of the present disclosure.

### DETAILED DESCRIPTION

### Definitions

Unless stated to the contrary, implicit from the context, or customary in the art, all parts and percents are based on weight.

The numerical ranges disclosed herein include all values from, and including, the lower value and the upper value. For ranges containing explicit values (e.g., 1 or 2, or 3 to 5, or 6, or 7) any subrange between any two explicit values is included (e.g., 1 to 2; 2 to 6; 5 to 7; 3 to 7; 5 to 6;

An "alpha-olefin" or "a-olefin" is a C₃₋₂₀ linear, branched or cyclic hydrocarbon molecule comprising an ethylenic unsaturation between the first and second carbon atoms. The term "alpha-olefin" also includes ethylene.

A "blend" or "polymer blend" is a composition of two or more polymers. Such a blend may or may not be miscible. Such a blend may or may not be phase separated. Such a blend may or may not contain one or more domain configurations, as determined from transmission electron spectroscopy, light scattering, x-ray scattering, and any other method known in the art.

A "composition" or "formulation" is a mixture or blend of two or more components. In the context of a mix or blend of materials from which an article of manufacture is fabricated, the composition includes all the components of the mix, e.g., polymers, catalysts, and any other additives or agents such as cure catalysts, antioxidants, flame retardants.

The terms "comprising," "including," "having" and like terms are not intended to exclude the presence of any additional component, step or procedure, whether or not the same is specifically disclosed. All processes claimed through use of "comprising" may include one or more additional steps, pieces of equipment or component parts, and/or materials unless stated to the contrary. In contrast, the term, "consisting essentially of" excludes from the scope of any succeeding recitation any other component, step or procedure, excepting those that are not essential to operability. The term "consisting of" excludes any component, step or procedure not specifically delineated or listed. The term "or," unless stated otherwise, refers to the listed members individually as well as in any combination.

"Direct contact" is a configuration whereby two components are in physical contact with each other with no intervening layer(s) and/or no intervening material(s) located between a portion of the two contacting components.

An "ethylene-based polymer" is a polymer that contains more than 50 mole percent polymerized ethylene monomer (based on the total amount of polymerizable monomers) and, optionally, may contain one comonomer.

"Glass" is a hard, brittle, transparent solid, such as that used for windows, bottles, or eyewear, including, but not limited to, pure silicon dioxide (SiO₂), soda-lime glass, borosilicate glass, sugar glass, isinglass (Muscovy-glass), photovoltaic glass or aluminum oxynitride.

An "ethylene/alpha-olefin interpolymer" is an interpolymer that comprises a majority amount (*i.e.,* over 50 mole percent) polymerized ethylene monomer (based on the total amount of polymerizable monomers) and one or more alpha-olefin comonomers.

The term "film," including when referring to a "film layer" in a thicker article, unless expressly having the thickness specified, includes any thin, flat extruded or cast thermoplastic article having a generally consistent and uniform thickness typically from 25 micrometers (µm) to 1.25 millimeters (mm) or more. "Layers" in films can be very thin, as in the cases of nanolayers, or microlayers. As used herein, the term "sheet," unless expressly having the thickness specified, includes any thin, flat extruded or cast thermoplastic article having a generally consistent and uniform thickness greater than a "film."

An "interpolymer" is a polymer prepared by the polymerization of two or more different types of monomers. This generic term includes copolymers, usually employed to refer to polymers prepared from two different types of monomers, and polymers prepared from more than two different types of monomers, e.g., terpolymers, tetrapolymers.

"Linear low density polyethylene" ("LLDPE") is an ethylene-based polymer and includes, in polymerized form, a majority weight percent of ethylene based on the total weight of the LLDPE and a C₃₋C₂₀ α-olefin comonomer. LLDPE is characterized by little, if any, long chain branching, in contrast to conventional LDPE.

"Low density polyethylene" ("LDPE") is an ethylene-based polymer and includes, in polymerized form, a majority weight percent of ethylene based on the total weight of the LDPE and optionally a C₃-C₂₀ α-olefin comonomer. LDPE is branched or heterogeneously branched polyethylene. LDPE has a relatively large number of long chain branches extending from the main polymer backbone. LDPE can be prepared at high pressure using free radical initiators, and typically has a density from 0.915 g/cc to 0.940 g/cc.

A "moisture-free environment" is an environmental condition having a relative humidity (RH) essentially of 0% or 0%.

A "polymer" is a polymeric compound prepared by polymerizing monomers, whether of the same or a different type. The generic term "polymer" thus embraces the term homopolymer, usually employed to refer to polymers prepared from only one type of monomer, and the term interpolymer.

A "propylene/alpha-olefin interpolymer" is an interpolymer comprising a majority amount (*i.e.,* over 50 mole percent) polymerized propylene monomer (based on the total amount of polymerizable monomers) and one alpha-olefin.

A "thermoplastic" is a material which is a linear polymer or a branched polymer which can be repeatedly softened and made flowable when heated and returned to a hard state when cooled to room temperature. Thermoplastics can be molded or extruded into articles of any predetermined shape when heated to the softened state.

A "polyolefin" or "PO" is a polymer that contains more than 50 mole percent polymerized olefin monomer (based on total amount of polymerizable monomers), and optionally, may contain one or more comonomer(s). Nonlimiting examples of olefin-based polymer include ethylene-based polymer and propylene-based polymer.

A "propylene-based polymer" is a polymer that contains more than 50 mole percent polymerized propylene monomer (based on the total amount of polymerizable monomers) and, optionally, may contain one comonomer.

### 1. Photovoltaic Module

The present disclosure provides a photovoltaic module (or "PV module"). A "photovoltaic module" is a laminated structure and includes the following layer components that are assembled into the final module structure:
1. a stiff or flexible transparent top layer (light receiving and transmitting layer, typically glass);
2. a front encapsulant layer (transparent);
3. a photovoltaic cell;
4. a rear encapsulant layer; and
5. a backsheet.

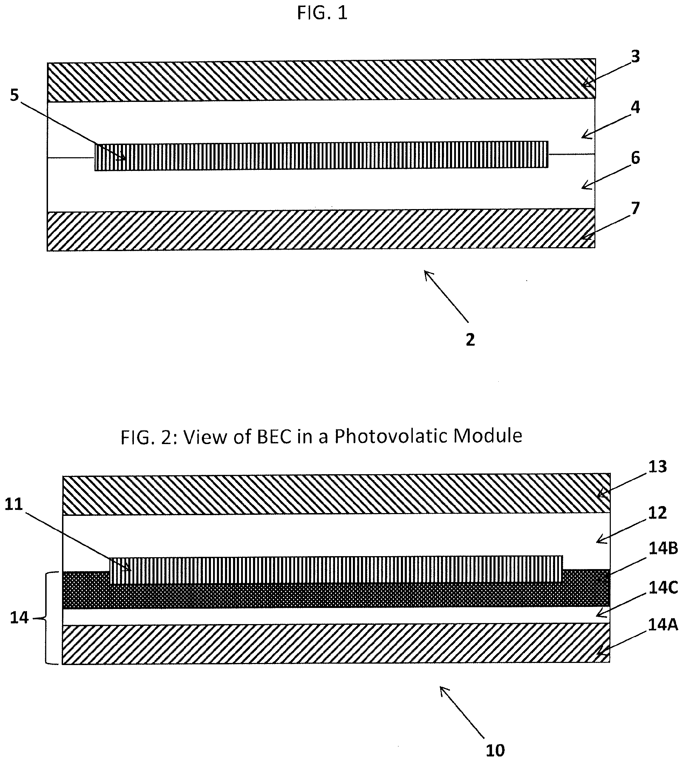

A PV module 2 is shown in Figure 1 and includes a top layer 3, a front encapsulant layer 4, at least one photovoltaic cell 5, typically a plurality of such cells arrayed in a linear or planar pattern, a rear encapsulant layer 6, and a backsheet 7. The front encapsulant layer 4 is in direct contact with both the photovoltaic cell 5 and also partially with the rear encapsulant layer 6. The front encapsulant layer 4 and the rear encapsulant layer 6 wholly surround, or encapsulate, the photovoltaic cell 5. The backsheet 7 can be a monolayer structure or a multilayer structure or glass (making glass/glass PV modules), which protects the back surface of a PV module 2. In an embodiment, the backsheet 7 contains a core polyethylene terephthalate (PET) layer.

The PV module includes one or more photovoltaic cells. A "photovoltaic cell" (or "PV cell") contains one or more photovoltaic effect materials of any of several inorganic or organic types. For example, commonly used photovoltaic effect materials include one or more of the known photovoltaic effect materials including but not limited to crystalline silicon, polycrystalline silicon, amorphous silicon, copper indium gallium (di)selenide (CIGS), copper indium selenide (CIS), cadmium telluride, gallium arsenide, dye-sensitized materials, and organic solar cell materials.

The number of photovoltaic cells in a given photovoltaic module will vary depending on the nature and use of the electronic device utilizing the photovoltaic module. The layers (1)-(5) of the PV module with laminated structure described above are bonded through lamination. Through lamination, the top sheet is brought into direct contact with the front encapsulant film, and the backsheet is brought into direct contact with the rear encapsulant film. The photovoltaic cells are secured between, and in direct contact with, the front encapsulant film and the rear encapsulant film. As a result, portions of the front encapsulant film and the rear encapsulant film are in direct contact with each other.

The present PV module includes a photovoltaic cell (as described above) and a layer composed of a film. The film includes a silane-grafted polyolefin (Si-g-PO) resin composition that contains (i) one or more silane-grafted polyolefins and (ii) greater than 0 wt% to less than 5.0 wt% of a micronized synthetic silica gel. The film has a glass adhesion greater than or equal to 15N/mm after aging the film at 40°C and 0% relative humidity for 60 days as measured in accordance with ASTM F88/88M-09.

It is desirable to have good adhesion within all layers of a PV module to decrease likelihood of delamination of layers within the module leading to moisture ingress, corrosion of metallic components and subsequent lower power efficiency and hence lower useful lifetime. Glass as the typical top layer can form bonds via inorganic oxides present on its surface; Similarly, many typical photovoltaic cells such as crystalline silicon can offer oxide surfaces able to form siloxane bonds. To achieve good adhesion between layers of the module, a product having high adhesion to oxide surfaces such as glass as well as to other polymeric layers is desirable. The ability to deliver a good adhesion versus time and storage condition is one key factor that determines good product shelf life. Studying adhesion in PV modules is currently an active area of study (see, for example, Degradations of Silicon Photovoltaic Modules: A Literature Review, 96 Solar Energy 140-151 (2013)).

### 2. Film Layer

The PV module includes a layer. The layer is a film layer and contains a resin composition composed of (i) one or more silane-grafted-polyolefins and (ii) from greater than 0 wt% to less than 5.0 wt% of a micronized silica gel. This composition is hereafter referred to as a "Si-g-PO resin composition."

For the polyolefin component of the Si-g-PO resin composition, the sole monomer (or the primary monomer in the case of interpolymers) is selected from ethylene, propene (propylene), 1-butene, 4- methyl-l-pentene, 1-hexene, 1-octene, 1-decene, 1-dodecene, 1-tetradecene, 1-hexadecene, and 1-octadecene. If the polyolefin resin is an interpolymer, then the comonomer(s) different from the first or primary monomer is/are typically one or more α-olefins. For purposes of this disclosure, ethylene is an α-olefin if propylene or a higher olefin is the primary monomer. The co-α-olefin is then a different C₂₋₂₀ linear, branched or cyclic α-olefin. Examples of C₂₋₂₀ α-olefins for use as comonomers include ethylene, propene (propylene), 1-butene, 4-methyl-l-pentene, 1-hexene, 1-octene, 1-decene, 1-dodecene, 1-tetradecene, 1-hexadecene, and 1-octadecene.

In an embodiment, the alpha-olefins for use as comonomers can also contain a cyclic structure such as cyclohexane or cyclopentane, resulting in an alpha-olefin such as 3-cyclohexyl-l-propene (allyl cyclohexane) and vinyl cyclohexane. Although not alpha-olefins in the classical sense of the term, for purposes of this disclosure certain cyclic olefins, such as norbornene and related olefins, are α-olefins and can be used as comonomer in place of some or all of the α-olefins described above.

In an embodiment, styrene and its related olefins (for example, a-methylstyrene, etc.) can be used as a comonomer if the polyolefin resin is an interpolymer.

In an embodiment, acrylic and methacrylic acid and their respective ionomers, and acrylates and methacrylates can be used as a comonomer if the polyolefin is an interpolymer.

Nonlimiting examples of suitable polyolefin copolymers include, but are not limited to, ethylene/propylene, ethylene/butene, ethylene/hexene, ethylene/octene, ethylene/styrene, polar ethylene copolymer such as ethylene/acrylic acid (EAA), ethylene/methacrylic acid (EMA), ethylene/acrylate or methacrylate, ethylene vinyl acetate and the like. Illustrative terpolymers include ethylene/propylene/octene, ethylene/propylene/butene, ethylene/butene/octene, and ethylene/butene/styrene. The copolymers can be random or blocky.

In an embodiment, the polyolefin is an ethylene-based polymer (such as ethylene/α-olefin interpolymer), a propylene-based polymer (such as a propylene/α-olefin interpolymer), a polar ethylene copolymer (such as ethylene vinyl acetate, and combinations thereof).

In an embodiment, the polyolefin is an ethylene/alpha-olefin interpolymer. Ethylene/alpha-olefin interpolymer may be a random ethylene/alpha-olefin interpolymer or a block ethylene/alpha-olefin interpolymer. The alpha-olefin is selected from propylene, 1-butene, 4-methyl-1-pentene, 1-hexene, 1-octene, 1-decene, 1-dodecene, 1-tetradecene, 1-hexadecene, 1-octadecene, 3-cyclohexyl-1-propene (allyl cyclohexane), vinyl cyclohexane, and combinations thereof. The ethylene/alpha-olefin interpolymer has an alpha-olefin content of from 1 mole percent (mole %), or 4 mole %, or 5 mole %, or 10 mole %, to 15 mole %, or 20 mole %, or 30 mole %. Mole % is based on the comonomers in the interpolymer.

In an embodiment, the ethylene/alpha-olefin interpolymer is selected from ethylene/propylene copolymer, ethylene/butene copolymer, ethylene/1-hexene copolymer, ethylene/1-octene copolymer, linear low density polyethylene, low density polyethylene, and combinations thereof.

In an embodiment, the ethylene/alpha-olefin interpolymer has one, some, or all of the following properties:
a density of from 0.85 g/cc, or 0.86 g/cc, or 0.88 g/cc, or 0.885 g/cc to 0.89 g/cc, or 0.90 g/cc, or 0.905 g/cc;
a melting point, Tm, from 90°C, or 95°C, or 100°C, to 105°C, or 110°C;
a glass transition temperature, Tg, from -50°C, or -45°C, or -40°C, to -35°C, or -30°C;
a melt index (MI) from 1 g/10 min, or 5 g/10 min, or 10 g/10 min, or 20 g/10 min, or 35 g/10 min to 50 g/10 or 75 g/10 min, or 100 g/10 min (190°C/2.16 kg);
a 2% secant modulus from 100 MPa, or 120 MPa to 150 MPa, or 200 MPa; and
a short chain branch distribution index (SCBDI) or composition distribution branch index (CDBI) from 30, or 40, or 50 to 70, or 80, or 90. As used herein, "SCBDI" and "CDBI" are defined as the weight percent (wt%) of the polymer molecules having comonomer content within 50% of the median total molar comonomer content.

Nonlimiting examples of ethylene/alpha-olefin interpolymers with a 2% secant modulus from 100 MPa, or 120 MPa to 150 MPa, or 200 MPa, and SCBDI or CDBI from 30, or 40, or 50 to 70, or 80, or 90 include ethylene/alpha-olefin interpolymers available under the trade name ENGAGE, such as ENGAGE 8200, ENGAGE 8402, ENGAGE 8450, ENGAGE D9077.15 and ENGAGE 8150G, available from The Dow Chemical Company.

In an embodiment, the ethylene/alpha-olefin interpolymer is a thermoplastic ethylene/alpha-olefin interpolymer.

In an embodiment, the ethylene/alpha-olefin interpolymer is an ethylene/1-octene copolymer.

Blends of any of the polyolefins described above may also be used, and the polyolefin may be blended or diluted with one or more other polymers to the extent that the polymers are (i) miscible with one another, (ii) the other polymers have little, if any, impact on the desirable properties of the ethylene interpolymer (*i.e.,* optics and low modulus), and (iii) the content of ethylene/alpha-olefin interpolymer(s) constitute at least 50 wt%, at least 60 wt%, at least 70 wt%, at least 75 wt%, or at least 80 wt% of the blend.

When a blend of two or more polyolefins is used, the overall MI of the blend is from 1 g/10 min, or 1.5 g/10 min, or 2 g/10 min, or 20 g/10 min, or 35 g/10min to 50 g/10, or 75 g/10 min, or 100 g/10 min.

In an embodiment, the polyolefin component of the silane-grafted polyolefin (Si-g-PO) is a polar ethylene copolymer. The polar ethylene copolymer is selected from ethylene vinyl acetate (EVA), ethylene ethyl acrylate (EEA), ethylene methacrylate (EMA) and ethylene n-butyl acrylate (EnBA), and combinations thereof. The polar ethylene copolymer has a melt index (MI) from 0.3 g/10 min, or 0.7 g/10 min, or 1.0 g/10 min to 30 g/10 min, or 50 g/10 min, or 75 g/10 min, or 100 g/10 min (190°C/2.16 kg).

In an embodiment, the polar ethylene copolymer is EVA. EVA copolymer is generally semi-crystalline, flexible and has good optical properties, e.g., high transmission of visible and UV-light and low haze. The EVA copolymer contains from 20 wt%, or 24 wt%, or 26 wt%, or 28 wt% to 30 wt%, or 33 wt%, or 34 wt%, or 35 wt% units derived from vinyl acetate. The EVA copolymer is made by an emulsion, solution or high-pressure polymerization.

To improve the adhesion of the polyolefin resin composition when incorporated into a PV module, silane functionality is introduced to the polyolefin. The polyolefin also benefits from being crosslinked at the time of contact or after, usually shortly after, the PV module has been constructed. Crosslinking enhances the thermal creep resistance of the Si-g-PO resin composition and durability of the module by increasing heat, impact and solvent resistance.

Silane functionality is introduced to the polyolefin by grafting or otherwise bonding an alkoxysilane to the polyolefin. In an embodiment, an alkoxysilane group having the following general Formula (I) is grafted to the polymer:

- CH₂-CHR¹-(R²)ₘ -Si(R³)₃₋ₙ(OR⁴)ₙ Formula (I)

wherein R¹ is H or CH; R² and R³ are, independently, an alkyl, aryl or hydrocarbyl containing from 1 to 20 carbon atoms and may also include other functional groups, such as esters, amides, and ethers; m is 0 or 1; R⁴ is an alkyl or carboxyalkyl containing from 1 to 6 carbon atoms; and n is 1, 2 or 3. In an embodiment, R⁴ is a methyl or ethyl group. In an embodiment n is 3.

Nonlimiting examples of suitable alkoxysilane compound for grafting include unsaturated alkoxysilanes where (1) the ethylenically unsaturated hydrocarbyl groups in formula (I) can be a vinyl, allyl, isopropenyl, butenyl, cyclohexenyl, or (meth)acryloxyalkyl (refers to acryloxyalkyl and/or methacryloxyalkyl) group, (2) the hydrolysable group (OR⁴) can be a hydrocarbyloxy, hydrocarbonyloxy, or hydrocarbylamino group such as methoxy, ethoxy, propoxy, butoxy, formyloxy, acetoxy, propionyloxy and alkyl- or arylamino groups, and (3) the saturated hydrocarbyl group (R³) can be methyl or ethyl.

In an embodiment, the alkoxysilane is selected from vinyltrimethoxysilane (VTMOS), vinyltriethoxysilane (VTEOS), allyltrimethoxysilane, allyltriethoxysilane, 3-acryloylpropyltrimethoxysilane, 3-acryloylpropyltriethoxysilane, 3-methacryloylpropyltrimethoxysilane, and 3-methacryloylpropyltriethoxysilane and combinations of these silanes.

In an embodiment, the alkoxysilane compound is VTMOS.

In an embodiment, the silane-grafted polyolefin (Si-g-PO) contains from 0.1 wt%, or 0.5 wt%, or 0.75 wt%, or 1.0 wt%, or 1.2 wt%, or 2 wt% to 5 wt% to less than 10 wt%, alkoxysilane, based on the total weight of the silane-grafted polymer.

In an embodiment, the Si-g-PO resin composition includes a silane-grafted ethylene/alpha-olefin interpolymer grafted with VTMOS. The ethylene/alpha-olefin is ethylene/1-octene copolymer and contains from 0.1 wt%, or 0.5 wt%, or 0.75 wt%, or 1.0 wt%, or 1.2 wt%, or 2 wt % to 5 wt% to less than 10 wt% VTMOS.

The silane can be grafted to the polyolefin before, during, or after extrusion of the film and/or lamination of the film to the PV module.

In an embodiment, VTMOS is grafted to ethylene/alpha-olefin interpolymer during film extrusion in the making of an encapsulant film.

In an embodiment, polyolefin, silane, and peroxide are blended and extruded at low temperature to not affect grafting and then grafting and crosslinking are achieved during high temperatures of the lamination step.

The silane-grafted polyolefin may comprise two or more embodiments disclosed herein.

### 3. Micronized Silica Gel

The silane-grafted polyolefin (Si-g-PO) resin composition used in the film layer includes one or more Si-g-POs and also micronized silica gel. The micronized silica gel is present in an amount from greater than 0 wt% to less than 5.0 wt%, based on total weight of the Si-g-PO resin composition. In a further embodiment, the silane-grafted polyolefin (Si-g-PO) resin composition of the film includes from greater than 0 wt%, or 0.1 wt%, or 1.5 wt%, or 2.0 wt%, or 2.5 wt%, or 3.0 wt% to 3.5 wt%, or 4.0 wt%, or 4.5 wt%, or 4.9 w%, or less than 5.0 wt% micronized synthetic silica gel.

"Micronized silica gel" (or "MSG") is a synthetic amorphous silica that has (i) a primary particle size from 1 µm, or 2 µm, or 3 µm, or 4 µm, or 5 µm to 6 µm, or 7 µm, or 8 µm, or 9 µm, or less than 10 µm, and (ii) an aggregate particle size greater than 1 µm, or 2 µm, or 3 µm, or 5 µm, or 10 µm to 12 µm, or 15 µm, or 17 µm, or 19 µm, or less than 20 µm, or 20 µm. "Primary particle size" is the median value of the volume distribution of the primary particles and is measured using a Malvern Mastersizer from Malvern Instruments Ltd. "Aggregate particle size" is the median value of the volume distribution of the aggregate particles and is measured using a Malvern Mastersizer from Malvern Instruments Ltd.

Synthetic amorphous silica (SAS) is a form of silicon dioxide (SiO₂) that is intentionally manufactured, thereby differentiating it from naturally occurring amorphous silica, e.g., diatomaceous earth. As a manmade product, SAS is nearly 100% pure amorphous silica whereas naturally occurring amorphous silica also contains crystalline forms of silica. SAS can be made into two forms that are characterized by their distinct manufacturing practices: wet process silica, which includes precipitated silica and silica gel, and thermal process silica, which includes pyrogenic silica (also known as fumed silica). The largest production volume is for precipitated silica followed by pyrogenic silica and then silica gel.

Synthetic amorphous precipitated silica and silica gels are manufactured using a wet process that involves an alkali metal silicate solution (or water glass) and acids, typically sulfuric acid. The process steps involve precipitation, filtration, washing, drying, milling, and granulation, followed by packing and shipping of the product. The size of the primary particles and the amount of aggregation and agglomeration are determined by the manufacturing processes' reaction conditions, e.g., pH, temperature, concentration, and amount of agitation. Silica gels are generally manufactured under acidic conditions with primary particles in the range of 1-10 nanometers (nm) that quickly adhere to form aggregates ranging from 1-20 micrometers (µm) upon drying.

Precipitated silica products are manufactured under neutral/alkaline conditions with primary particles in the range of 5-100 nm, aggregates ranging from 0.1-1 µm, and agglomerates ranging from 1-250 µm. Once formed, the agglomerate is tightly bound together and extremely difficult to break apart. This physical property prevents the formation of small (nano) particles. "Agglomerate particle size" is the median value of the volume distribution of the agglomerate particles and is measured using a Malvern Mastersizer from Malvern Instruments Ltd.

After precipitation, the various silica products are filtered using different techniques (e.g., filter press, membrane filter press, or belt/drum filter) depending on the product being manufactured. At this stage, the product is also washed to remove any salts. The product may then be dried either by plate, belt, rotary drum or spray dryers. The final stage of the manufacturing process is milled to get the desired particle size distribution. The final product is a white, fluffy or powdery amorphous form of silicon dioxide with a high degree of purity with trace amount of other metal oxides, sulfates and/or chlorides.

A list of physical and chemical properties of SAS forms is given in Table 1.

**Table 1. Properties of Synthetic Amorphous Silica (SAS)**

| Physical and Chemical Properties of Specific SAS Forms (ECETOC, 2006) | | | |
|---|---|---|---|
| | Pyrogenic | Precipitated | Gel |
| **Property (units)** | | | |
| Purity, % SiO₂ (by weight) | >99.8 | >95 | >95 (dry) |
| Color | White | White | White |
| Specific surface area (BET, m²/g) | 50-400 | 30-500 | 250-1,000 |
| Loss on drying (% by weight) | <2.5 | 5-7 | 2-6 |
| pH | 3.6-4.5 | 5-9 | 3-8 |
| Tapped (bulk) density (g/L) | 30-250 | 30-500 | >500-1,000 |
| Ignition loss (% by weight) | <2 | 3-14 | 2-15 |

| **Particle Size** | | | |
|---|---|---|---|
| Primary particle (nm) | 5-50 | 5-100 | 1-10 |
| Aggregate (µm) | 0.1-1 | 0.1-1 | 1-20 |
| Agglomerate (µm) | 1-250* | 1-250* | NA |

| **Porosity** | | | |
|---|---|---|---|
| Mean pore size (µm) | None | >0.03 | 0.0001-1 |
| Pore size distribution | None | Very Wide | Narrow |
| Specific gravity (g/cm³) | 2.2 | 1.9-2.2 | 1.8-2.2 |
| Structure, DBP absorption (ml/100g) | 250-350 | 80-320 | 80-350 |

| | | | |
|---|---|---|---|
| *Agglomerate particle size is typically 100 µm | | | |

The present micronized silica gel (MSG) has a specific pore volume from 0.4 ml/g, or 0.5 ml/g, or 1.0 ml/g, or 1.5 ml/g, or 1.6 ml/g, or 1.8 ml/g, or 1.9 ml/g to less than 2.0 ml/g. "Specific pore volume" is the pore volume per unit mass of material. "Pore volume" is the volume of open pores in the material. "Open pores" are cavities or channels in the material with access to an external surface. The specific pore volume is determined using an ASAP 2100 nitrogen adsorption measurement apparatus from Micromeritics.

The present micronized silica gel is distinct from pyrogenic or fumed silica. The term "fumed silica," as used herein, is a non-crystalline, fine-grain, low bulk density and high surface area silica. Fumed silica primary particle size is 5-50 nm. Fumed silica particles are non-porous and typically have a specific surface area of 50-400 m²/g and a bulk density of 30-250 g/L. Fumed silica is typically made from flame pyrolysis of silicon tetrachloride or from quartz sand vaporized in a 3,000°C electric arc. Fumed silica consists of chain-shaped aggregates and agglomerate particle size of about 100 µm.

The present micronized silica gel is distinct from precipitated silica. The present micronized silica gel (MSG) has a different pore structure compared to precipitated silica. Precipitated silica has a broad meso/macroporous pore structure reflected in the pore size distribution with an average pore size of greater than 30 nm. MSG has a more narrow microporous or mesoporous structure (sponge like) with a much smaller mean pore size of less than 1 µm. Precipitated silica has a bulk density of 30-500 g/L whereas MSG has a bulk density from greater than 500 g/L to 1,000 g/L.

In an embodiment, the micronized silica gel has one, some, or all of the following additional properties:
- a mean pore size from 0.0001 µm, or 0.001 µm to 0.01 µm, or 0.02 µm, or less than 0.03 µm;
- a bulk density from greater than 500 g/L, or 600 g/L, or 750 g/L to 800 g/L, or 900 g/L, or 1000 g/L; and
- an oil absorption from 200g/100g, or 225g/100g, or 250g/100g to 275g/100g, or 280g/100g, or 290g/100g, or 300g/100g.

"Mean pore size" is the mean of pore size distribution determined by adsorption isotherms, assuming cylindrical-shaped pores, as described in E.M. Voigt & R.H. Tomlinson, The Determination of Pore Size Distribution and Surface Area from Adsorption Isotherms, 33 Canadian J. of Chemistry 215-231 (1954). Mean pore size effectively provides the pore diameter, assuming pores have a cylindrical shape. "Macropores" are pores having a diameter greater than 50 nm (0.05 µm) (IUPAC). "Mesopores" are pores having a diameter from 2 nm to 50 nm (0.002 µm to 0.05 µm) (IUPAC). "Micropores" are pores having a diameter less than 2 nm (0.002 µm) (IUPAC).

Bulk density is the ratio of the mass of a collection of discrete pieces of solid material to the sum of the volumes of the solids in each piece, the voids within the pieces and the voids among the pieces of the particular collection. Bulk density is measured according to ASTM D3766.

Oil absorption is measured according to ASTM D 1483.

Non-limiting examples of a suitable micronized synthetic silica gels are micronized synthetic silica gels sold under the tradename SYLOBLOC 44 and SYLOBLOC 47 available from WR Grace and Company Columbia, Maryland.

In an embodiment, the micronized silica gel is a surface-modified micronized silica gel (or "SM-MSG"). The surface-modified micronized silica gel has a surface coating to modify the outer surface. The surface coating can modify the wettability, the adhesion, and/or the compatibility of the micronized silica gel with the base resin-*i.e*., the Si-g-PO. The surface-modified micronized silica gel contains a carboxylic acid on an outer surface of the silica gel. The carboxylic acid forms a surface coating (whole or partial) on the particles of the MSG. The carboxylic acid may or may not be water soluble. The carboxylic acid may be a strong acid or a weak acid. In an embodiment, the organic acid is a multiple pKa acid. The SM-MSG has the same properties as the MSG as described above.

In an embodiment, the surface coating is a carboxylic acid that is selected from citric acid, isocitric acid, aconitic acid, propane-1,2,3-tricarboxylic acid, and combinations thereof. In a further embodiment, the surface coating is a carboxylic acid that is citric acid.

In an embodiment, the SM-MSG has a pH from 3.0, or 3.5 to 4.0, or 4.3, or 4.5, or 4.9, or less than 5.0.

A nonlimiting example of SM-MSG is SYLOBLOC 45 available from WR Grace and Company Columbia, Maryland.

Applicant discovered that SM-MSG does not exhibit a negative interaction (*i.e*., reaction, crosslinking, binding, with a Si-g-PO base resin and shows no enhanced gel formation, particularly with silane-grafted ethylene/alpha-olefin interpolymer base resins. Applicant also discovered that the SM-MSG does not exhibit negative interactions with any other additives (e.g., antioxidants, UV stabilizers, flame retardants, process aids, slip aids, antistats, buffers, used in a Si-g-PO resin composition.

The micronized silica gel (and the SM-MSG) may comprise two or more embodiments disclosed herein.

### 4. Other Additives

The Si-g-PO resin composition may contain one or more additives in addition to the micronized synthetic silica gel. Nonlimiting examples of suitable additives include other polymers, UV stabilizers, antioxidants, crosslinking agents, scorch inhibitors, anti-slip agents, anti-block agents, pigments, fillers, and combinations thereof. These additives may be provided in known quantities, and, in some embodiments, may be added in the form of a master batch, that is pre-blended in an amount of polymer composition.

In an embodiment, the Si-g-PO resin composition contains from greater than 0 wt% to 4.5 wt% of micronized silica gel and from 0 wt%, or greater than 0 wt% to 5 wt% of an inorganic antiblock agent. In a further embodiment, the Si-g-PO polyolefin resin composition contains from 0 wt%, or greater than 0 wt% to 5 wt% precipitated synthetic silica in addition to the MSG.

In an embodiment, the Si-g-PO resin composition includes a crosslinking agent. Nonlimiting examples of suitable crosslinking agents include Lewis acids such as dibutyltin dilaurate, dioctyltin dilaurate, stannous octonoate, and hydrogen sulfonates and photoinitiators such as organic carbonyl compounds, including benzophenone, benzanthrone, benzoin and alkyl ethers thereof, 2,2-diethoxyacetophenone, 2,2-dimethoxy, 2 phenylacetophenone, p-phenoxy dichloroacetophenone, 2-hydroxycyclohexylphenone, 2-hydroxyisopropylphenone, and 1-phenylpropanedione-2-(ethoxy carboxyl)oxime. Crosslinking agents are used in an amount from 0.05 wt%, or 0.1 wt%, or 0.5 wt% to less than 10 wt%, or less than 5 wt%, or less than 3 wt%, based on the total weight of the Si-g-PO resin.

Further nonlimiting examples of crosslinking agent include free radical crosslinking co-catalysts which may be used in an amount from 0.05 wt%, or 0.1 wt%, or 0.5 wt% to less than 10 wt%, or less than 5 wt%, or less than 3 wt%, based on the total weight of the Si-g-PO resin.

In an embodiment, the Si-g-PO polyolefin resin composition includes a crosslinking agent and the Si-g-PO resin composition has a gel content of from 10%, or 20% to 30%, or 40%, or 50%, or 60%, or 70% or 80%. Gel content is measured in accordance with ASTM D-2765.

In an embodiment, the Si-g-PO resin composition includes a scorch inhibitor. Nonlimiting examples of suitable scorch inhibitors include organic hydroperoxides, N-nitroso diphenylamine, N,N'-dinitroso-para-phenylamine, isoamyl nitrite, tert-decyl nitrite, monomeric vinyl compounds, aromatic amines, phenolic compounds, mercaptothiazole compounds, bis(N,N-disbustituted-thiocarbamoyl) sulfides, hydroquinones, dialkyldithiocarbamate compounds, mixtures of metal salts of disubstituted dithiocarbamic acid, 4-hydroxy-2,2,6,6-tetramethylpiperidin-1-oxyl.

In an embodiment, the Si-g-PO polyolefin resin composition contains from 0.01 wt%, or 0.05 wt%, or 0.1 wt%, or 0.15 wt% to 1.0 wt%, or 1.5 wt%, or 1.7 wt%, or 2 wt%, of a peroxide, based on the total weight of the Si-g-PO resin composition.

In an embodiment, the Si-g-PO resin composition includes a UV stabilizer. Nonlimiting examples of suitable UV stabilizers include hindered phenols, phophites, hindered amine light stabilizers (HALS), UV absorbers, hindered benzoates, and combinations of these. In an embodiment, the HALS and hindered benzoates include, but are not limited to, CYNERGY A400, A430 and R350; CYASORB UV-3529; CYASORB UV-3346; CYASORB UV-3583; Hostavin® N 30; Uvinul® 4050H; Uvinul®5050H; Chimassorb® UV-119; Chimassorb® 944 LD; TINUVIN 622 LD and the like. In an embodiment, the UV absorbers include benzophenones, benzotriazoles, triazines, and combinations of these, such as TINUVIN 328 or CYASORB UV-1164.

In an embodiment, the Si-g-PO resin composition includes one or more other additives selected from processing stabilizers, antioxidants, anti-slips, pigments and fillers. In an embodiment, the antioxidant is selected from the group consisting of CYANOX 2777; Irganox® 1010; Irganox® 1076; Irganox® B 215; Irganox® B 225; PEPQ; WESTON 399; TNPP; IRGAFOS 168; and Doverphos® 9228.

Additional optional additives include the slip additives erucamide and stearamide; process aids such as Dyneon fluropolymer elastomers (like Dynamar® FX5930); pigments and fillers such as DuPont TiO₂ products numbered R960, R350, R105, R108 or R104 and carbon blacks such as provided in Dow DNFA-0037 or DFDB-5410 master batches and others such as provided by Cabot.

### 5. Glass Adhesion/Retention

The film composed of the present Si-g-PO resin composition has a glass adhesion greater than 15 N/mm after aging the film at 40°C and 0% relative humidity for 60 days as measured in accordance with ASTM F88/88M-09. In an embodiment, the film composed of the present Si-g-PO resin composition has a glass adhesion from greater than 15 N/mm, or 16 N/mm, or 17 N/mm, or 18 N/mm to 19 N/mm, or 20 N/mm after aging the film at 40°C and 0% relative humidity for 60 days as measured in accordance with ASTM F88/88M-09.

The film composed of the present Si-g-PO resin composition has a glass adhesion retention greater than 80%. In an embodiment, the film composed of the present Si-g-PO resin composition has a glass adhesion retention from greater than 80%, or 81%, or 85%, or 90%, or 95% to 98%, or 99%, or 100%, or 101%, or 105%.

In an embodiment, the Si-g-PO resin composition present in the film layer of the PV module includes from 0.1 wt% to 4.5 wt% micronized silica gel.

In an embodiment, the Si-g-PO resin composition present in the film layer of the PV module includes a micronized silica gel that has a specific pore volume from 0.4 ml/g to 1.8 ml/g.

In an embodiment, the Si-g-PO resin composition present in the film layer of the PV module includes a micronized silica gel that is a surface-modified micronized silica gel.

In an embodiment, the Si-g-PO resin composition present in the film layer of the PV module includes a surface-modified micronized silica gel having a carboxylic acid surface coating on an outer surface of the micronized synthetic silica gel particles. In a further embodiment, the carboxylic acid surface coating on the MSG particles is selected citric acid, isocitric acid, aconitic acid, propane-1,2,3-tricarboxylic acid, and combinations thereof.

The layer composed of the present Si-g-PO resin composition can be a front encapsulant layer, a rear encapsulant layer, a backsheet film, and combinations thereof. The present Si-g-PO resin composition can be formed into a film, or a layer (*i.e.,* a film layer) and can form, or be a component of any of the foregoing layers in the layer structure for the PV module.

In an embodiment, the layer containing the Si-g-PO resin composition is the front encapsulant layer. The front encapsulant layer is in direct contact with the photovoltaic cell. In a further embodiment, the front encapsulant layer containing the present Si-g-PO resin composition is a monolayer structure and has a thickness from 25 µm, or 50 µm, or 75 µm, or 100 µm, or 150 µm, or 200 µm, or 250 µm to 300 µm, or 350 µm, or 400 µm, or 450 µm, or 500 µm, or 550 µm, or 600 µm, or 640 µm.

In an embodiment, the layer containing the Si-g-PO resin composition is the rear encapsulant layer. The rear encapsulant layer is in direct contact with the photovoltaic cell. In a further embodiment, the rear encapsulant layer containing the present Si-g-PO resin composition is a monolayer structure and has a thickness from 25 µm, or 50 µm, or 75 µm, or 100 µm, or 150 µm, or 200 µm, or 250 µm to 300 µm, or 350 µm, or 400 µm or 450 µm, or 500 µm, 550 µm, or 600 µm, or 640 µm.

In an embodiment, the present Si-g-PO resin composition is present in both the front encapsulant layer and the rear encapsulant layer. The PV module includes a front encapsulant layer composed of the Si-g-PO resin composition and a rear encapsulant layer composed of the Si-g-PO resin composition. Each of the front encapsulant layer and the rear encapsulant layer directly contact the photovoltaic cell. A portion of the front encapsulant layer also directly contacts a portion of the rear encapsulant layer. The front encapsulant layer and the rear encapsulant layer can be as previously described.

### 6. Blocking Force

In an embodiment, film composed of the present silane-g-PO resin composition exhibits reduced blocking force. Blocking is the adhesion of two adjacent layers of film, and the blocking force is the force required to separate the two adjacent layers of film. For example, when a single film is wound into a roll for storage, the film may block to itself. The "blocking force" is the force required to separate the film from itself such as during unwinding. In particular, for a wound roll of film, the inside layer of the film can block to the outside layer of the film.

Blocking is also important in assembly of PV modules. In PV modules, a portion of the front encapsulant layer is in direct contact with the rear encapsulant layer. If the blocking force between the front encapsulant layer and rear encapsulant layer is too high, the layers will adhere too much to one another on contact and it will be difficult to adjust the placement of the layers prior to lamination.

When the film containing the present Si-g-PO resin composition is a monolayer structure-a monolayer a front encapsulant layer and/or a monolayer rear encapsulant layer-the blocking force is measured between two Si-g-PO resin composition-containing layers (hereinafter referred to as "encapsulant/encapsulant blocking force").

In an embodiment, film layers containing the Si-g-PO resin composition have an encapsulant/encapsulant blocking force at 50°C from 0 grams, or greater than 0 grams or 10 grams, or 20 grams, or 30 grams, or 40 grams to 50 grams, or 75 grams or 100 grams, as measured in accordance with ASTM D3354-11. In a further embodiment, film layers containing the Si-g-PO resin composition have an encapsulant/encapsulant blocking force at 40°C from 0 grams, or greater than 0 grams or 10 grams, 15 grams, or 20 grams, or 25 grams to 30 grams, or 40 grams or 50 grams as measured in accordance with ASTM D3354-11.

### 7. Photovoltaic Module with BEC

The present disclosure provides another device. In an embodiment, a photovoltaic module is provided and includes a photovoltaic cell and a back encapsulant composite (BEC). The BEC includes a top encapsulant layer (B), a bottom layer (A) and a tie layer (C) between the layer (B) and the layer (A). The top encapsulant layer (B) includes the present silane-grafted polyolefin (Si-g-PO) resin composition where the silane is grafted onto the polyolefin of the top encapsulant layer (B) either before or during the BEC film extrusion. In an embodiment, the silane is grafted onto the polyolefin of the top encapsulant layer (B) before the BEC film is extruded. The BEC has a glass adhesion greater than or equal to 4 N/mm after aging the film at 40°C and 0% relative humidity for 60 days as measured in accordance with ASTM F88/88M-09.

The PV module containing the back encapsulant composite (BEC) has the following structure:
1. a stiff or flexible transparent top layer (light receiving and transmitting layer, typically glass);
2. a front encapsulant layer (transparent);
3. a photovoltaic cell; and
4. a BEC.

The "back encapsulant composite" or "BEC" is an integrated backsheet and has the following multilayer structure:
a top encapsulant layer (B)
a tie layer (C); and
a bottom layer (A).

The BEC is particularly suited for uses as an integrated or combined protective backsheet and encapsulated layer in PV modules. Exemplary BEC multilayer films are described in WO Publication No. 2013/003543.

A PV module with a BEC is shown in Figure 2 and includes at least one photovoltaic cell 11, typically a plurality of such cells arrayed in a linear or planar pattern, a top layer 13, typically a glass cover sheet over the front facial surface of the cell, a front encapsulant layer 12 encapsulating the front side of the cell, and a BEC 14. The BEC includes top encapsulant layer 14B, a tie layer 14C and a bottom layer 14A. The BEC top encapsulant layer 14B is in direct contact with both the back surface of the photovoltaic cell 11 and also partially with the front encapsulant layer 12 encapsulating the front side of the cell. The top encapsulant layer 14B of the BEC exhibits good adhesion to both the device and the top encapsulant layer material 12.

In an embodiment, an optional rear encapsulant layer (not shown) may be present between the photovoltaic cell 11 and the top encapsulant layer 14B.

In an embodiment, the photovoltaic cell 11 is deposited or attached directly to the top layer 13 (such as glass) eliminating the front encapsulant layer. In this construction, the BEC adheres directly to the top layer 13 (likely glass) as well as to the photovoltaic cell 11. This results in a need for the BEC film to have good glass adhesion.

The BEC 14 acts as a substrate and supports a rear surface of the photovoltaic cell 11. The BEC 14 (and optional rear encapsulant layer) need not be light transmitting if the surface of the PV cell to which it is opposed is not effective, *i.e.,* reactive to sunlight. In the case of a flexible PV module, as the description "flexible" implies, it would comprise a flexible thin film photovoltaic cell 11.

In an embodiment, the overall thickness for the BEC 14, prior to lamination into the PV module, is from 0.2 mm to 1.5 mm (from 8 mils to 60 mils). In a further embodiment, the BEC 14 has a thickness from 0.25 mm (10 mils), or 0.4 mm (16 mils) to 1.05 mm (42 mils), or 0.95 mm (38 mils). The thicknesses described above include any optional, additional layers that form and are an integral part of the multilayer BEC film structure.

The top encapsulant layer 14B of the BEC includes the Si-g-PO resin composition. The Si-g-PO resin composition (with one or more Si-g-POs and greater than 0 wt% to less than 5.0 wt% MSG) can be any Si-g-PO resin composition previously disclosed herein. In an embodiment, the top encapsulant layer 14B is a monolayer structure and has a thickness from 0.15 mm, or 0.20 mm, or 0.25 mm, or 0.30 mm to 0.50 mm or 0.625 mm, or 0.875 mm, 1.0 mm, or 1.25 mm.

For the BEC film, the silane is grafted to the polyolefin before or during the making of the BEC since the temperatures required in a feedblock and die to co-extrude the remaining layers (tie and bottom layer) are typically too high to avoid grafting during the extrusion.

### 8. BEC Glass Adhesion/Retention

The BEC with top encapsulant layer (B) composed of the present Si-g-PO resin composition has a glass adhesion greater than 4N/mm after aging the film at 40°C and 0% relative humidity for 60 days as measured in accordance with ASTM F88/88M-09. In an embodiment, the BEC with top encapsulant layer (B) composed of the present Si-g-PO resin composition has a glass adhesion from greater than 4 N/mm, or 5 N/mm, or 5.2 N/mm, or 5.5 N/mm to 6 N/mm, or 7 N/mm after aging the film at 40°C and 0% relative humidity for 60 days as measured in accordance with ASTM F88/88M-09.

The BEC with top encapsulant layer (B) composed of the present Si-g-PO resin composition has a glass adhesion retention after aging the film at 40°C and 0% relative humidity for 60 days greater than 80%. In an embodiment, the film composed of the present Si-g-PO resin composition has a glass adhesion retention (after aging the film at 40°C and 0% relative humidity for 60 days) from greater than 80%, or 81%, or 85%, or 90%, or 95% to 98%, or 99%, or 100%, or 101%, or 105%.

In an embodiment, the BEC film includes the Si-g-PO resin composition in the top encapsulant layer (B) and the Si-g-PO resin composition includes from 0.1 wt% to 4.5 wt% micronized silica gel.

In an embodiment, the BEC film includes the Si-g-PO resin composition in the top encapsulant layer (B) and the micronized silica gel has a specific pore volume from 0.4 ml/g to 1.8 ml/g.

In an embodiment, the BEC film includes the Si-g-PO resin composition in the top encapsulant layer (B) and the micronized silica gel is a surface-modified micronized silica gel. The surface-modified micronized silica gel comprises a carboxylic acid surface coating on an outer surface of the micronized synthetic silica gel particles. In a further embodiment, the carboxylic acid surface coating on the MSG particles is selected from citric acid, isocitric acid, aconitic acid, propane-1,2,3-tricarboxylic acid, and combinations thereof.

In an embodiment, the top encapsulant layer (B) is in direct contact with the photovoltaic cell.

In an embodiment, the photovoltaic module includes a front encapsulant layer in direct contact with the photovoltaic cell. The front encapsulant layer is composed of the silane-grafted polyolefin (Si-g-PO) resin composition comprising one or more Si-g-POs and from 0.1 wt% to less than 5.0 wt% of a micronized silica gel, based on the total weight of the Si-g-PO resin composition. In a further embodiment, the front encapsulant layer containing the present Si-g-PO resin composition is a monolayer structure and has a thickness from 25 µm, or 50 µm, or 75 µm, or 100 µm, or 150 µm, or 200 µm, or 250 µm to 300 µm, or 350 µm, or 400 µm, or 450 µm, or 500 µm, or 550 µm, or 600 µm, or 640 µm.

In an embodiment, the front encapsulant layer is in direct contact with the photovoltaic module and is also in direct contact with the top encapsulant layer (B) of the BEC. Each of the front encapsulant layer and the top encapsulant layer (B) contains the Si-g-PO resin composition.

In an embodiment, the BEC includes the Si-g-PO resin composition in the top encapsulant layer (B). The bottom layer (A) is composed of a material with a melting temperature greater than 125°C and selected from propylene-based polymer, high-density polyethylene (HDPE), polyamide, and combinations thereof.

### 9. Blocking Force for BEC

For the BEC, the blocking force is measured between the top encapsulant layer (B) (the layer containing the Si-g-PO resin composition) and the bottom layer (A) and is referred to as "inside of film to outside of film blocking" or "in to out blocking" or "in/out blocking." In an embodiment, BEC bottom layer (A) is composed of polypropylene (PP), and the blocking force measured as in/out blocking is referred to herein as "encapsulant/PP blocking force."

For BEC, the blocking force is also measured between the front encapsulant layer and top encapsulant layer (B) of the BEC and is referred to as "encapsulant/BEC blocking force."

In an embodiment, films containing the Si-g-PO resin composition have a front encapsulant/BEC blocking force at 50°C from 0 grams, or greater than 0 grams, or 10 grams, or 20 grams, or 30 grams, or 40 grams to 50 grams, or 75 grams, or 100 grams, as measured in accordance with ASTM D3354-11. In a further embodiment, films containing the Si-g-PO resin composition have an encapsulant/BEC blocking force at 40°C from 0 grams, or greater than 0 grams, or 10 grams, or 15 grams, or 20 grams, or 25 grams to 30 grams, or 40 grams, or 50 grams as measured in accordance with ASTM D3354-11.

In an embodiment, the BEC has an encapsulant/PP blocking force of 0 grams at 40°C or lower, or 50 grams or less at 50°C, or 100 grams or less at 60°C to 0 grams, as measured in accordance with ASTM D3354-11.

Applicant discovered that films (or film layers) containing the silane-g-PO resin composition with micronized silica gel have improved shelf life as reflected by increased glass adhesion after aging the film for 60 days at 40°C an 0% relative humidity prior to lamination.

Applicant unexpectedly discovered that PV modules having the structure of glass/front encapsulant layer/photovoltaic cell/rear encapsulant layer/glass, where the rear encapsulant layer includes the Si-g-PO resin composition, show reduced black streak. It is observed that under high temperature and high humidity aging, the back of PV modules show black streaks and bubbles at the encapsulant-photovoltaic cell interface. Bounded by no particular theory, it is believed that the high humidity conditions lead to moisture inside the PV module and a chemical reaction etching the alumina coating on the back of the photovoltaic cell. The chemical reaction also leads to production of hydrogen gas as a byproduct which causes the bubbles. Applicant discovered that use of the silane-g-PO resin composition in the rear encapsulant layer reduces and/or prevents the black streak failure and bubble formation at the encapsulant-cell interface.

### 10. Electronic Devices

The PV modules disclosed herein may be a component of an electronic device. Nonlimiting examples of electronic devices include solar arrays, distributed power systems, rooftop power systems, and utility power systems.

Some embodiments of the present disclosure will now be described in detail in the following examples.

### EXAMPLES

### Materials

Antiblock agents used in the examples are described in Table 2.

**Table 2: Properties of Antiblock Agents**

| | Primary Particle Size (µm) | Aggregate Particle Size (µm) | Specific Pore Volume (ml/g) | Mean Pore Size (µm) | Oil Absorption (g/100g) | pH | Tapped (Bulk) Density (g/L) | Material Description |
|---|---|---|---|---|---|---|---|---|
| SM-MSG (45) | 4.7 | 1-20 | 1.0 | 0.0001-1 | 200 | 3.0-4.3 | >500-1,000 | SYLOBLOC 45--Micronized synthetic silica gel, citric acid surface modified |
| MSG (47) | 5.8 | 1-20 | 1.0 | 0.0001-1 | 200 | 6.0-8.0 | >500-1,000 | SYLOBLOC 47--Micronized synthetic silica gel |
| MSG (44) | 5.0 | 1-20 | 1.6 | 0.0001-1 | 300 | 6.0-8.0 | >500-1,000 | SYLOBLOC 44--Micronized synthetic silica gel |
| p-silica* | 5.0 | 0.1-1 | -- | >0.03 | 85 | 6.0-8.0 | 30-500 | SYLOBLOC P05-Synthetic silica from precipitate |
| Diatomaceous Earth* | 11 | -- | -- | -- | 130 | 10 | -- | Mined crystalline SiO₂ |
| Minbloc® HC1400* | 7.6 | -- | -- | -- | 31 | 9.9 | -- | Nepheline syenite |
| CaCO₃* | 21 | -- | -- | -- | 20 | 9.0-9.5 | -- | Mined limestone |

| | | | | | | | | |
|---|---|---|---|---|---|---|---|---|
| *Comparative | | | | | | | | |

The backsheet used in the examples is PROTEKT HD from Madico (EVA seal layer/PET/Fluoro-coating).

"Luperox 101 peroxide" is 2,5-bis(tert-butylperoxy)-2,5-dimethylhexane, provided by Arkema Inc.

"E/O 1" is ENGAGE 8200, an ethylene/octene interpolymer with a density of 0.870 g/cc, a melting point of 59.0°C, a glass transition temperature of -53.0°C, and MI of 5 g/10 min, available from The Dow Chemical Company, Midland, Michigan.

"E/O 2" is ENGAGE 8402, an ethylene/octene interpolymer with a density of 0.902 g/cc, a melting point of 96.0°C, a glass transition temperature of -36.0°C, and MI of 30 g/10 min, available from The Dow Chemical Company, Midland, Michigan.

"E/O 3" is ENGAGE 8450, an ethylene/octene interpolymer with a density of 0.902 g/cc, a melting point of 97.0°C, a glass transition temperature of -32.0°C, and MI of 3 g/10 min, available from The Dow Chemical Company, Midland, Michigan.

"E/O 5" is ENGAGE D9077.15, an ethylene/octene interpolymer with a density of 0.870 g/cc, a melting point of 118°C, a glass transition temperature of -65°C, and MI of 0.5 g/10 min, available from The Dow Chemical Company, Midland, Michigan.

"E/O 6" is ENGAGE 8150G, an ethylene/octene interpolymer with a density of 0.870 g/cc, a melting point of 55°C, a glass transition temperature of -52°C and MI of 0.5 g/10 min, available from The Dow Chemical Company, Midland, Michigan.

"Silane" is vinyl trimethoxy silane, provided by Dow Corning, Inc.

"Masterbatch 1" is a masterbatch with a proprietary blend of UV and antioxidant stabilizers made with carrier resin ENGAGE 8200, available from The Dow Chemical Company. ENGAGE 8200 is an ethylene/octene copolymer having a density of 0.870 g/cc, a melting point of 59.0°C, a glass transition temperature of -53.0°C and an MI of 5 g/10 min.

"Antiblock Masterbatch 2" contains Masterbatch 1 along with 20 wt% SYLOBLOC 45 in E/O 1.

"PP1" is PP D118, a high crystalline propylene homopolymer with a melt flow rate of 8.0 g/10 min and a melting point of 168°C, available from Braskem.

"TiO₂, or titanium dioxide" is Ampacet® 110883-A White PP MB, available from Ampacet Corp., a white pigment master batch containing 50% TiO₂ in a polypropylene homopolymer having a MFR of 20 g/10 min.

"Dyneon" is Ampacet® 102823, available from Ampacet Corp., a polymer processing aid (PPA) master batch containing 2% dyneon as processing aid in a linear low density polyethylene (LLDPE) having a MI of 2.0 g/10 min.

"Cynergy 1" is ADD-VANCE 861R, available from Addcomp-North America, a master batch containing 26% CYNERGY R350-4a in a homopolymer polypropylene having a MFR of 12 g/10 min.

"Cynergy 2" is ADD-VANCE 861T, available from Addcomp-North America, a master batch containing 25% CYNERGY A430 in a LLDPE having a MI of 20 g/10 min.

"Naugard" is ADD-VANCE 861G, available from Addcomp-North America, a master batch containing 20% NAUGARD 412S (beta-laurylthiopropionate available from Addivant) in a homopolymer polypropylene having a MFR of 12 g/10 min.

"CBC" is a crystalline block copolymer composite that includes EP/iPP (ethylenepropylene/isotactic polypropylene) block copolymers that have 90 wt% ethylene (C2) in the EP block and approximately 50 wt% crystalline EP blocks/50 wt% crystalline iPP blocks. The CBC has a MFR of 9.5 g/10 min and a density of 0.9048 g/cc (density measured in accordance with ASTM D4703, A1 Proc C, Test within 1 hour). Exemplary crystalline block copolymer composites are discussed in WO Publication No. 2013/003543.

"TiO₂/LLDPE" is Ampacet® 110456 White PE MB, available from Ampacet Corp., a white pigment master batch containing 50% TiO₂ in a LLDPE having a MI of 20 g/10 min.

"Minbloc in LLDPE" is Ampacet® 103240 AB, available from Ampacet Corp., a master batch of 50% Minbloc® HC1400 in a LLDPE having a MI of 20 g/10 min.

"Sylobloc 45 in LLDPE" is a master batch of 20% SYLOBLOC 45 in a LLDPE having a MI of 20 g/10 min. Sylobloc 45 in LLDPE master batch is available from Ampacet Corp.

"CaCO3 in LLDPE" is Ampacet® 103805, available from Ampacet Corp., a masterbatch of 70 wt% calcium carbonate in a LLDPE having a MI of 20 g/10min.

"DE in LLDPE" is Ampacet® 101736, available from Ampacet Corp., a masterbatch of 50 wt% diatomaceous earth in a LLDPE having a MI of 20 g/10min.

"Minbloc in LDPE" is Ampacet® 101830-U, available from Ampacet Corp., a masterbatch of 50 wt% Minbloc® HC1400 in a LDPE having a MI of 7 g/10min.

Silane graft resin 1 is a silane-grafted resin made with a blend of E/O1 and E/O3.

"Affinity" is AFFINITY™ PL-1880G, an ethylene/1-octene copolymer with a density of 0.902 g/cc, a MI of 1.0 g/10 min and a Tm of 99.0°C, available from The Dow Chemical Company.

### Test Methods

The primary particle size is the median value of the volume distribution of the primary particles and is determined using methods and equipment known in the art, such as a Malvern Mastersizer from Malvern Instruments Ltd.

The aggregate particle size is the median value of the volume distribution of the aggregate particles and is determined using methods and equipment known in the art, such as a Malvern Mastersizer from Malvern Instruments Ltd.

The agglomerate particle size is the median value of the volume distribution of the agglomerate particles and is determined using methods and equipment known in the art, such as a Malvern Mastersizer from Malvern Instruments Ltd.

The specific pore volume is determined using an ASAP 2100 nitrogen adsorption measurement apparatus from Micromeritics. Specific pore volume is the pore volume per unit mass of material, and may be measured as described in Paul A. Webb, Volume and Density Determinations for Particle Technologists, Micrometritrics Instrument Corp. (16 Feb. 2001).

Oil absorption is as reflected in product literature for the respective products and determined according to ASTM D1483.

Density is determined according to ASTM-D 792-03, Method B, in isopropanol, and reported in g/cc.

Glass transition temperature, Tg, is determined from the DSC heating curve where half the sample has gained the liquid heat capacity as described in B. Wunderlich in Thermal Characterization of Polymeric Materials, 2nd edition, Academic Press, 1997, E. Turi ed., pg 278 and 279. Baselines are drawn from below and above the glass transition region and extrapolated through the Tg region. The temperature at which the sample heat capacity is halfway between these baselines is the Tg.

"Melting point" or "Tm," as used herein (also referred to as a melting peak in reference to the shape of the plotted DSC curve) is typically measured by the DSC (Differential Scanning Calorimetry) technique for measuring the melting points or peaks of polyolefins as described in USP 5,783,638. It should be noted that many blends comprising two or more polyolefins will have more than one melting point or peak, many individual polyolefins will comprise only one melting point or peak.

Melt index (MI) is measured in accordance with ASTM D-1238 (190°C/2.16 kg) and reported in g/10 min.

Secant modulus (2%) is measured in accordance with ASTM D-882.

Short chain branch distribution index (SCBDI) or composition distribution branch index (CDBI) of a polymer is calculated from data obtained from temperature rising elution fractionation (TREF) as described, for example, in Wild et al., Journal of Polymer Science, Poly. Phys. Ed., vol. 20, p. 441 (1982), in USP 4,798,081 and 5,008,204, or as described in B. Monrabal et al., Crystallization Elution Fractionation. A New Separation Process for Polyolefin Resins, 257 Macromolecular Symposia 71-79 (2007).

Haze is measured on a BYK Gardner Haze Gard at 23°C and 50%RH averaging 5 samples of single ply film having 450 µm thickness according to ASTM D1003.

### Glass Adhesion

The sample for glass adhesion is laminated. The procedure for encapsulant film adhesion measurement includes laying a piece of 100 mm x 100 mm Teflon film on one side of a solar glass plate measuring 100 mm x 150 mm followed by two 100 mm x 150 mm plys of encapsulant and then one 100 mm x 150 mm ply of backsheet. The procedure for BEC film adhesion measurement includes laying a piece of 100 mm x 100 mm Teflon film on one side of a solar glass plate measuring 100 mm x 150 mm followed by one 100 mm x 150 mm ply of BEC film. Then the glass/encapsulant/encapsulant/backsheet or glass/BEC layup is placed in a laminator with glass side to heated platen. The sample is then laminated at 150°C with a vacuum cycle of 3 minutes without added pressure and then with applied pressure of 750 mbar for 7 minutes thereafter. The laminate is removed from the press and placed on a table to cool. The laminate is conditioned at 23°C/50% relative humidity for 24 hours. Three strips of 1 inch width are scored on the backsheet cutting though the backsheet and encapsulant to the glass. The Teflon sheet is removed providing a lip to perform adhesion measurement between glass and encapsulant by peel test according to ASTM F88/88M-09. The force required to separate the film from the glass is recorded using an Instron Tester 5965 for 180° peels at a crosshead speed of 50 mm/min. For each sample, an average of three measurements is reported. Glass adhesion is reported as Newtons (N) per millimeter (mm) or N/mm. The conditioning of films in Table 4 is conditioning performed before the lamination is performed.

### Glass Adhesion Retention

A. For monolayer encapsulant films, glass adhesion retention is calculated by determining the percent of total glass adhesion retained after aging at 40°C and 0% relative humidity for 60 days (2 months), before lamination to the glass, compared to the glass adhesion of an identical film after aging at 23°C and 0% relative humidity for 60 days (2 months), before lamination to glass. Aging is performed by placing the encapsulant film in a foil bag, sealing foil bag, and then subjecting the sealed foil bag to the aforementioned heat conditions. The relative humidity inside the sealed foil bag is 0%.
B. For BEC, glass adhesion retention is calculated by determining the percent of total glass adhesion retained after aging at 40°C and 0% relative humidity for 60 days (2 months), before lamination to the glass, compared to the glass adhesion of an identical film which is not aged (*i.e*., fresh film) before lamination to glass. Aging is performed by placing the encapsulant film in a foil bag, sealing foil bag, and then subjecting the sealed foil bag to the aforementioned heat conditions. The relative humidity inside the sealed foil bag is 0%.

Blocking is determined in accordance with ASTM D3354-11 where the two film samples are placed in contact with one another between glass plates at the designated temperature for 24 hr under 1725 Pa pressure. The blocking is expressed as the load (in grams) required to separate the two layers of film.

### Glass Adhesion of Encapsulant Films (Reflective of Shelf Life)

The Si-g-PO resin is compounded using a twin screw reactive extrusion process, cut into pellets, and stored in a foil bag. The composition of the silane-g-PO resin is provided in Table 3, below.

**Table 3: Composition of Silane-g-PO Resin in Percent Based on Total Weight (wt%)**

| | Resin 1 |
|---|---|
| E/O1 | 83.3 |
| E/O3 | 14.7 |
| Silane | 1.90 |
| Luperox 101 peroxide | 0.095 |

Master batches of antiblock agents ("Antiblock Master Batches") are also prepared at 120°C using a HAAKE™ Rheomex CTW 100 OS Twin Screw Extruder (Thermo Scientific), followed by a water bath to cool and strand cut the pellets. Unless otherwise indicated, Antiblock Master Batches contain 10 wt% inorganic antiblock additive (as detailed in Table 4) in E/O1.

In some examples, commercially available Antiblock Master Batches are used as detailed in Table 4.

Films are made by co-extruding on a 3-layer mini-cast line (Killion Extruders Inc., KL-100 and KTS-100). The three extruders are all 25 mm diameter with Maddock mixing sections at the screw end. Die width is 300 mm. Three layers of the same formulation as shown in Tables 3 and 4 (below) are extruded into one monolayer film of 450 micrometers thickness according to conditions given in Table 5 (below). Film rolls are enclosed immediately after making them by heat sealing the film rolls in foil barrier bags to provide a constant dry atmosphere. Films are then aged for 60 days at 40°C in an air oven at 0% relative humidity (RH) or at 23°C at 50% relative humidity prior to laminating the adhesion test samples.

**Table 4: Monolayer Film Composition**

| Ex. No. | Resin 1 (wt%) | Master Batch 1 (wt%) | Antiblock Master Batch (wt%) | Type of Antibloc | Total Antiblock in Film (wt%) | Glass Adhesion (N/mm) | | Glass adhesion % retention | Haze |
|---|---|---|---|---|---|---|---|---|---|
| | | | | | | 60 days, 23°C | 60 days, 40°C | | |
| CS1 | 80 | 10 | 10 | Control* | 0 | 17.9 | 12.5 | 70*%* | 16 |
| E1 | 80 | 10 | 10 | Sylobloc 45 | 1 | 18.8 | 18.7 | 99% | 6 |
| E2 | 80 | 10 | 20 | Sylobloc 45 | 2 | 18.8 | 18.9 | 101% | - |
| E3 | 80 | 10 | 10 | Sylobloc 47 | 1 | 18.8 | 18.4 | 98% | - |
| E4 | 80 | 10 | 10 | Sylobloc 44 | 1 | 19.3 | 17.9 | 93% | - |
| CS2 | 80 | 10 | 10 | Sylobloc P05 | 1 | 18.6 | 9.9 | 53% | - |
| CS3 | 80 | 10 | 10 "DE in LLDPE" | Diatomaceous Earth | 5 | 15.5 | 7.6 | 49% | - |
| CS4 | 80 | 10 | 10 "Minbloc in LDPE" | Minbloc HC1400 | 5 | 13.6 | 2.4 | 18% | - |
| CS5 | 80 | 10 | 10 "CaCO3 in LLDPE" | CaCO₃ | 7 | 18.1 | 15.0 | 83% | 96 |

| | | | | | | | | | |
|---|---|---|---|---|---|---|---|---|---|
| *Control Antibloc Master Batch is E/O1 only. CS = comparative sample E = inventive example | | | | | | | | | |

**Table 5: Processing Conditions**

| MiniCast Line, Larkin 200 | | | |
|---|---|---|---|
| Extruder | A | C | B |
| RPM | 30 | 30 | 30 |
| Feed Zone (°C) | 163 | 163 | 163 |
| Zone 2 (°C) | 177 | 177 | 177 |
| Zone 3 (°C) | 191 | 191 | 191 |
| Transfer line, screen, adapters (°C) | 199 | 199 | 199 |
| Feedblock (°C) | | | 199 |
| Die (°C) | | | 199 |
| Cast roll (°C) | | | 21 |

As shown in Table 4, Examples 1-4 contain micronized silica gel and show higher glass adhesion (and higher glass adhesion retention) after aging the films for 60 days at 40°C/0%RH prior to lamination to the glass. Surprisingly, Examples 1 and 2, using the citric acid surface modified micronized silica gel (having a pH of 3.0-4.3) show the highest glass adhesion and glass adhesion retention (and therefore have the best shelf life) after aging at 40°C/0% RH for 60 days. Examples 3 and 4 also have high glass adhesion and glass adhesion retention after film aging for 60 days at 40°C/0%RH. Comparative Samples 2-5 in Table 4 show decreased glass adhesion and glass adhesion retention relative to Examples 1-4. Particularly, Comparative Samples 2-5 have a glass adhesion retention after aging at 40°C/0% RH for 60 days and between 18% and 83%.

### Glass Adhesion of BEC Films (Reflective of Shelf Life)

BEC films are made with the minicast line at Larkin 200. The BEC films have a B/C/A layer structure, with layer B being the top encapsulant and including the present Si-g-PO resin composition as described herein. Layer A is a polypropylene-based (PP-based) bottom layer. The processing conductions for the BEC multilayer film are provided in Table 6, below.

**Table 6: Processing Conditions**

| MiniCast Line, Larkin 200 | | | |
|---|---|---|---|
| Extruder | B | C | A |
| RPM | 75 | 15 | 60 |
| Feed Zone (°C) | 182 | 182 | 182 |
| Zone 2 (°C) | 196 | 196 | 196 |
| Zone 3 (°C) | 191 | 191 | 191 |
| Transfer line, screen, adapters (°C) | 191 | 191 | 191 |
| Feedblock (°C) | 191 | | |
| Die (°C) | 191 | | |
| Cast roll (°C) | 21 | | |

Three BEC multilayer films are prepared according to the formulations provided in Table 7, below.

**Table 7: Formulations of BEC Films in Percent Based on Weight**

| Sample | | CS6 (Control BEC) | | | | E5 | | | | CS7 | | |
|---|---|---|---|---|---|---|---|---|---|---|---|---|
| Total Film Thickness | | 19.7 mil (500.0 µm) | | | | 19.7 mil (500.0 µm) | | | | 19.7 mil (500.0 µm) | | |
| Extruder | | B | C | A | | B | C | A | | B | C | A |
| Layer vol (%) | | 50.0 | 10.0 | 40.0 | | 50.0 | 10.0 | 40.0 | | 50.0 | 10.0 | 40.0 |
| Layer Thickness (mil) | | 9.8 | 2.0 | 7.9 | | 9.8 | 2.0 | 7.9 | | 9.8 | 2.0 | 7.9 |
| Materials (wt%) | | | | | | | | | | | | |
| PP1 | | | | 50.0 | | | | 50.0 | | | | 50.0 |
| E/O 5 | | | | 27.0 | | | | 27.0 | | | | 27.0 |
| TiO₂/PP | | | | 8.0 | | | | 8.0 | | | | 8.0 |
| Dyneon | | | | 2.0 | | | | 2.0 | | | | 2.0 |
| Cynergy 1 | | | | 10.0 | | | | 10.0 | | | | 10.0 |
| Naugard | | | | 3.0 | | | | 3.0 | | | | 3.0 |
| E/O 6 | | | 10.0 | | | | 10.0 | | | | 10.0 | |
| CBC | | | 67.0 | | | | 67.0 | | | | 67.0 | |
| TiO₂/LLDPE | | | 20.0 | | | | 20.0 | | | | 20.0 | |
| Cynergy 2 | | | 3.0 | | | | 3.0 | | | | 3.0 | |
| Minbloc in LLDPE | | 0.0 | | | | 0.0 | | | | 5 | | |
| Sylobloc 45 in LLDPE | | 0.0 | | | | 12.5 | | | | 0.0 | | |
| Masterbatch 1 | | 10.0 | | | | 10.0 | | | | 10.0 | | |
| Affinity | | 20.0 | | | | 20.0 | | | | 20.0 | | |
| Silane graft resin 1 | | 70.0 | | | | 57.5 | | | | 65 | | |

| | | | | | | | | | | | | |
|---|---|---|---|---|---|---|---|---|---|---|---|---|
| CS = comparative sample E = inventive example | | | | | | | | | | | | |

The glass adhesion of the BEC multilayer films is tested on fresh films (no aging) and films aged in an oven at 40°C at 0%RH for 30 days, 60 days, and 120 days. The adhesion of CS6 (Control BEC) with no antiblock, Example 5 (Sylobloc 45), CS7 (Minbloc), BEC multilayer films to glass is shown in Table 8 below.

**Table 8: Glass Adhesion of BEC Films**

| Glass Adhesion (N/mm) | | | | |
|---|---|---|---|---|
| Film aging time, 40°C/0%RH | Fresh (no aging) | 30 days | 60 days | 120 days |
| CS6 (control BEC) | 3.6 | 0.35 | 0.15 | 0.09 |
| E5 (Sylobloc 45) | 5.3 | 5.2 | 5.0 | 4.3 |
| CS7 (Minbloc) | 3.3 | 0.58 | 0.04 | 0.10 |

| | | | | |
|---|---|---|---|---|
| CS = comparative sample E = inventive example | | | | |

**Table 9: Glass Adhesion Retention of BEC Films**

| Retention of Glass Adhesion (%) | | | | |
|---|---|---|---|---|
| Film aging time, 40°C/0%RH | Fresh (no aging) | 30 days (compared to fresh film) | 60 days (compared to fresh film) | 120 days (compared to fresh film) |
| CS6 (control BEC) | 100% | 10% | 4% | 2% |
| E5(Sylobloc 45) | 100% | 98% | 93% | 81% |
| CS7 (Minbloc) | 100% | 18% | 1% | 3% |

| | | | | |
|---|---|---|---|---|
| CS =comparative sample E = inventive example | | | | |

As shown in Tables 8 and 9, the glass adhesion for both comparative samples decreases with heat aging compared to Example 5 with micronized silica gel. Example 5 consistently has a glass adhesion of greater than or equal to 4 N/mm after up to 4 months of aging at 40°C/0% RH before lamination to the glass. Example 5 also has very minor adhesion loss (high glass adhesion retention), whereas the glass adhesion retention of comparative samples 6 and 7 decreases rapidly (low glass adhesion retention with aging), reflecting a poor shelf life. Example 5 has a glass adhesion retention of 93% after 60 days of aging (*i.e.,* its 60 day aged adhesion is only 7% lower than its initial adhesion). In contrast, the glass adhesion retention of the control (CS6) and CS7 decreases significantly after 30 days and at 60 days of film aging the glass adhesion retention of both films is only 4% or less of the initial adhesion.

The encapsulant/encapsulant blocking force of the Control CS6, Examples 5-7 and Comparative Samples 7-9 is measured at 23°C, 40°C, 50°C and 60°C and reported in Table 10, below. Examples 6 and 7 are the same as Example 5 with the exception that Examples 6 and 7 contain 1 wt% and 1.5 wt%, respectively, of Sylobloc 45. Comparative Samples 8 and 9 are the same as Comparative Sample 7 with the exception that Comparative Samples 8 and 9 contain 1 wt% and 4 wt%, respectively, of Minbloc HC1400. The amount of silane graft resin 1 In each of Examples 6 and 7 and Comparative Samples 8 and 9 is reduced accordingly to account for the change in antiblock loading levels.

**Table 10: BEC Encapsulant/BEC Encapsulant Blocking (g)**

| | CS 6 | Ex. 6 | Ex.7 | Ex. 5 | CS 8 | CS 7 | CS 9 |
|---|---|---|---|---|---|---|---|
| Antiblock added to Layer B | none | 1% Sylobloc 45** | 1.5% Sylobloc 45** | 2.5% Sylobloc 45** | 1% Minbloc | 2.5% Minbloc | 4% Minbloc |
| Blocking @ 23°C | 55 | 24 | 13 | 13 | 23 | 13 | 0 |
| Blocking @ 40°C | 154 | 31 | 14 | 13 | 57 | 47 | 13 |
| Blocking @ 50°C | 203 | 100 | no data | 25 | 160 | 106 | 104 |
| Blocking @ 60°C | 210 | 215 | 198* | 124 | 208 | 218 | 216 |

| | | | | | | | |
|---|---|---|---|---|---|---|---|
| *polymer process aid used in BEC Layer B **Sylobloc 45 = SM-MSG | | | | | | | |

Table 10 shows that as the antiblock loading level increases, the blocking force decreases. However, BEC films using micronized silica gel in layer B (examples 5-7) exhibit a blocking force of 100 grams or less at 50°C , and exhibit a blocking force of 50 grams or less at 40°C.

The PP/encapsulant blocking resistance of the control (Comparative Sample 6), Examples 5-7 and Comparative Samples 7-9 is measured at 23°C, 40°C, 50°C and 60°C and reported in Table 11, below.

**Table 11: PP/Encapsulant Blocking (g)**

| | CS6 | Ex. 6 | Ex.7 | Ex. 5 | CS8 | CS7 | CS9 |
|---|---|---|---|---|---|---|---|
| Antiblock added to Layer B | none | 1% Sylobloc 45** | 1.5% Sylobloc 45** | 2.5% Sylobloc 45** | 1% Minbloc | 2.5% Minbloc | 4% Minbloc |
| Blocking @ 23°C | 0 | 0 | 0* | 0 | 0 | 0 | 0 |
| Blocking @ 40°C | 0 | 0 | 0* | 0 | 0 | 0 | 0 |
| Blocking @ 50°C | 68 | 0 | no data | 0 | 41 | 0 | 0 |
| Blocking @ 60°C | 130 | 66 | 0* | 0 | 130 | 88 | 51 |

| | | | | | | | |
|---|---|---|---|---|---|---|---|
| *polymer process aid used in Layer B **Sylobloc 45 - citric acid surface modified micronized synthetic silica gel | | | | | | | |

Table 11 shows that the PP/Encapsulant blocking for BEC films containing 1.5 wt% Sylobloc 45 (Examples 5-7) or greater is 0 grams at all temperatures, even up to 60°C. In contrast, the blocking force for BEC films containing 1-4 wt% Minbloc (comparative samples 7-9) increases to 50 grams or greater at 60°C. This is surprising because the average size of Sylobloc 45 particles is lower than the average size of the Minbloc® HC1400 particles.

### Black Streak Testing

The silane-g-PO resin used in the black streak testing (Resin 3) is prepared from 98 wt% E/O 1, 1.905 wt% silane and 0.095 wt% Luperox 101 peroxide.

Masterbatch 1 as described above is used for black streak testing. A new master batch of inorganic antiblock agent ("Antiblock Masterbatch 2") is prepared at 120°C using a HAAKE™ Rheomex CTW 100 OS Twin Screw Extruder (Thermo Scientific) followed by a water bath to cool and strand cut the pellets. Antiblock Masterbatch 2 contains Masterbatch 1 along with 20 wt% SYLOBLOC 45 in E/O1.

Resin 3 is compounded using a twin screw reactive extrusion process, cut into pellets and stored in a foil bag. Separately, the Masterbatch 1 and Antiblock Masterbatch 2 are compounded using a twin screw extruder. Film samples with 457 µm thickness are prepared on a 3-layer cast co-extrusion line. The three extruders are all 25 mm in diameter with Maddock mixing sections and the screw end. The casting roll is always contacting the B extruder and the C extruder was always the core. Die width was 300 mm.

The encapsulant film is a three layer coextruded film with a single middle layer ("core") and two outer layers ("skins") having the formulations shown in Table 12.

**Table 12: Formulations of Encapsulant Films for Black Streak Testing**

| Example (3 layer film) | Skin Layers (10 vol% each skin layer) | Core Layer (80 vol%) |
|---|---|---|
| Comparative Sample 9 | 90 wt% Resin 3; | 90 wt% Resin 3; |
| | 10 wt% Masterbatch 1 | 10 wt% Masterbatch 1 |
| Example 8 | 87.5 wt% Resin 3; | 90 wt% Resin 3; |
| | 12.5 wt% Antiblock Masterbatch 2 | 8 wt% Masterbatch 1; |
| | | 2 wt% Antiblock Masterbatch 2 |

The encapsulant films are used in PV modules having the schematic structure glass/sample encapsulant (front encapsulant)/ photovoltaic cell/sample encapsulant (BEC)/glass. The PV modules are made in a vacuum bag laminator. Pre-assembled laminates are covered with Teflon sheets and placed into a P-Energy L200A laminator. The lamination condition used is 150°C with a pump time of 3 minutes and a hold time of 7 minutes at 1000 mBar. Laminates are pulled from the laminator and allowed to cool approximately 1 minute prior to removing the Teflon sheets.

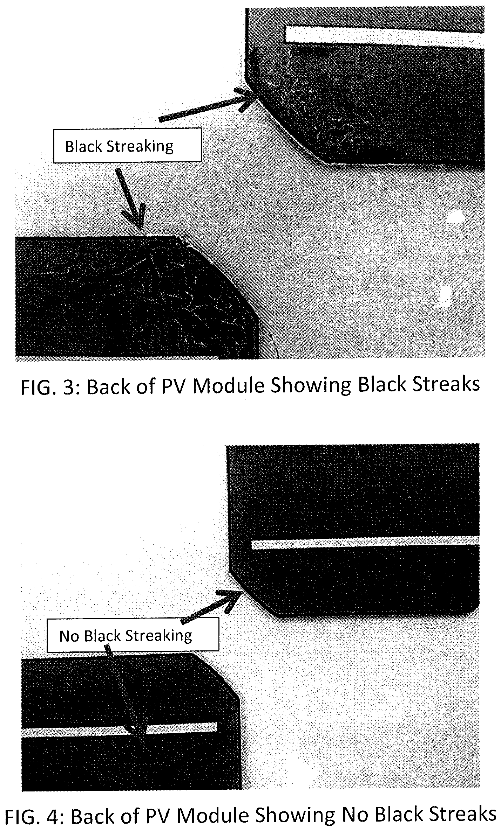

The PV modules are placed in a damp heat chamber (85°C, 85% RH) for accelerated aging. Figure 3 shows the back of Comparative Sample 9 after 1650 hours. Black streaks and bubbles are visible at the encapsulant/cell interface. In contrast, the back of Example 8 shown in Figure 4 is smooth with no bubbles or black streaks visible. Applicant surprisingly discovered that the present Si-g-PO composition (with MSG and SM-MSG in particular) reduces, or eliminates, black streaks in PV modules.

It is specifically intended that the present disclosure not be limited to the embodiments and illustrations contained herein, but include modified forms of those embodiments including portions of the embodiments and combinations of elements of different embodiments as come within the scope of the following claims.

## Claims

1. A photovoltaic module comprising:
a photovoltaic cell; and
a layer composed of a film comprising a silane-grafted polyolefin (Si-g-PO) resin composition comprising (i) one or more silane grafted polyolefins and (ii) from greater than 0 wt% to less than 5.0 wt% of a micronized silica gel, based on the total weight of the Si-g-PO resin composition;
wherein the micronized silica gel is a synthetic amorphous silica that has (a) a primary particle size from 1 µm to less than 10 µm and (b) an aggregate particle size from greater than 1 µm to 20 µm; and
the film has a glass adhesion greater than or equal to 15 N/mm after aging the film at 40°C and 0% relative humidity for 60 days as measured in accordance with ASTM F88/88M-09.

2. The photovoltaic module of claim 1 wherein the Si-g-PO resin composition comprises from 0.1 wt% to 4.5 wt% micronized silica gel.

3. The photovoltaic module of any of claims 1-2 wherein the micronized silica gel has a specific pore volume from 0.4 ml/g to 1.8 ml/g, wherein the specific pore volume is determined using ASAP 2100 nitrogen adsorption measurement apparatus from Micromeritics.

4. The photovoltaic module of any of claims 1-3 wherein the micronized silica gel is a surface-modified micronized silica gel.

5. The photovoltaic module of any of claims 1-4, wherein the layer is a front encapsulant layer in direct contact with the photovoltaic cell.

6. The photovoltaic module of any of claims 1-4 wherein the film layer is a rear encapsulant layer in direct contact with the photovoltaic cell.

7. The photovoltaic module of any of claims 1-4 comprising a front encapsulant layer comprising the Si-g-PO resin composition and a rear encapsulant layer comprising the Si-g-PO resin composition.

8. A photovoltaic module comprising:
a photovoltaic cell; and
a back encapsulant composite (BEC) comprising
a top encapsulant layer (B),
a bottom layer (A) and
a tie layer (C) between the layer (B) and the layer(A);
the top encapsulant layer (B) comprises a silane-grafted polyolefin (Si-g-PO) resin composition comprising (i) one or more silane grafted polyolefins and (ii) from greater than 0 wt% to less than 5.0 wt% of a micronized silica gel, based on the total weight of the Si-g-PO resin composition;
wherein the micronized silica gel is a synthetic amorphous silica that has (a) a primary particle size from 1 µm to less than 10 µm and (b) an aggregate particle size from greater than 1 µm to 20 µm; and
the BEC has a glass adhesion greater than or equal to 4 N/mm after aging the film at 40°C and 0% relative humidity for 60 days as measured in accordance with ASTM F88/88M-09.

9. The photovoltaic module of claim 8 wherein the Si-g-PO resin composition comprises from 0.1 wt% to 4.5 wt% micronized silica gel.

10. The photovoltaic module of any of claims 8-9 wherein the micronized silica gel has a specific pore volume from 0.4 ml/g to 1.8 ml/g, wherein the specific pore volume is determined using ASAP 2100 nitrogen adsorption measurement apparatus from Micromeritics.

11. The photovoltaic module of any of claims 8-9 wherein the micronized silica gel is a surface-modified micronized silica gel.

12. The photovoltaic module of any of claims 8-11 wherein the top encapsulant layer (B) is in direct contact with the photovoltaic cell.

13. The photovoltaic module of any of claims 8-12, further comprising a front encapsulant layer in direct contact with the photovoltaic cell, the front encapsulant layer composed of the silane-grafted polyolefin (Si-g-PO) resin composition comprising a Si-g-PO and from 0.1 wt% to less than 5.0 wt% of a micronized silica gel, based on the total weight of the Si-g-PO resin composition.

14. The photovoltaic module of any of claims 8-13, wherein the bottom layer (A) comprises a material with a melting temperature greater than 125°C and the material is selected from the group consisting of polypropylene, high-density polyethylene (HDPE), polyamide, and combinations thereof.

15. A photovoltaic module comprising:
a photovoltaic cell; and
a layer composed of a film comprising (i) one or more polyolefins, at least one alkoxysilane, and at least one peroxide and (ii) from greater than 0 wt% to less than 5.0 wt% of a micronized silica gel, based on the total weight of the Si-g-PO resin composition, wherein the micronized silica gel is a synthetic amorphous silica that has (a) a primary particle size from 1 µm to less than 10 µm and (b) an aggregate particle size from greater than 1 µm to 20 µm; and
the film has a glass adhesion greater than or equal to 15 N/mm after aging the film at 40°C and 0% relative humidity for 60 days as measured in accordance with ASTM F88/88M-09.

## Patentansprüche

1. Ein Photovoltaikmodul, beinhaltend:
eine Photovoltaikzelle; und
eine Schicht, aufgebaut aus einer Folie, beinhaltend eine silangepfropfte Polyolefin(Si-g-PO)-Harzzusammensetzung, beinhaltend (i) ein oder mehrere silangepfropfte Polyolefine und (ii), bezogen auf das Gesamtgewicht der Si-g-PO-Harzzusammensetzung, zu mehr als 0 Gew.-% bis weniger als 5,0 Gew.-% ein mikronisiertes Kieselgel;
wobei das mikronisierte Kieselgel ein synthetisches amorphes Siliciumdioxid ist, das (a) eine Primärpartikelgröße von 1 µm bis weniger als 10 µm und (b) eine Aggregatpartikelgröße von mehr als 1 µm bis 20 µm aufweist; und
die Folie nach Altern der Folie bei 40 °C und 0 % relativer Luftfeuchtigkeit für 60 Tage eine Glashaftung von mehr als oder gleich 15 N/mm aufweist, wie in Übereinstimmung mit ASTM F88/88M-09 gemessen.

2. Photovoltaikmodul gemäß Anspruch 1, wobei die Si-g-PO-Harzzusammensetzung 0,1 Gew.-% bis 4,5 Gew.-% mikronisiertes Kieselgel beinhaltet.

3. Photovoltaikmodul gemäß einem der Ansprüche 1-2, wobei das mikronisierte Kieselgel ein spezifisches Porenvolumen von 0,4 ml/g bis 1,8 ml/g aufweist, wobei das spezifische Porenvolumen unter Verwendung eines ASAP 2100-Stickstoffadsorptionsmessgeräts von Micromeritics bestimmt wird.

4. Photovoltaikmodul gemäß einem der Ansprüche 1-3, wobei das mikronisierte Kieselgel ein oberflächenmodifiziertes mikronisiertes Kieselgel ist.

5. Photovoltaikmodul gemäß einem der Ansprüche 1-4, wobei die Schicht eine vordere Verkapselungsschicht in direktem Kontakt mit der Photovoltaikzelle ist.

6. Photovoltaikmodul gemäß einem der Ansprüche 1-4, wobei die Folienschicht eine hintere Verkapselungsschicht in direktem Kontakt mit der Photovoltaikzelle ist.

7. Photovoltaikmodul gemäß einem der Ansprüche 1-4, beinhaltend eine vordere Verkapselungsschicht, beinhaltend die Si-g-PO-Harzzusammensetzung, und eine hintere Verkapselungsschicht, beinhaltend die Si-g-PO-Harzzusammensetzung.

8. Ein Photovoltaikmodul, beinhaltend:
eine Photovoltaikzelle; und
einen rückseitigen Verkapselungsverbundwerkstoff (BEC), beinhaltend eine obere Verkapselungsschicht (B),
eine untere Schicht (A) und
eine Verbindungsschicht (C) zwischen der Schicht (B) und der Schicht (A);
wobei die obere Verkapselungsschicht (B) eine silangepfropfte Polyolefin(Si-g-PO)-Harzzusammensetzung beinhaltet, beinhaltend (i) ein oder mehrere silangepfropfte Polyolefine und (ii), bezogen auf das Gesamtgewicht der Si-g-PO-Harzzusammensetzung, zu mehr als 0 Gew.-% bis weniger als 5,0 Gew.-% ein mikronisiertes Kieselgel;
wobei das mikronisierte Kieselgel ein synthetisches amorphes Siliciumdioxid ist, das (a) eine Primärpartikelgröße von 1 µm bis weniger als 10 µm und (b) eine Aggregatpartikelgröße von mehr als 1 µm bis 20 µm aufweist; und
der BEC nach Altern der Folie bei 40 °C und 0 % relativer Luftfeuchtigkeit für 60 Tage eine Glashaftung von mehr als oder gleich 4 N/mm aufweist, wie in Übereinstimmung mit ASTM F88/88M-09 gemessen.

9. Photovoltaikmodul gemäß Anspruch 8, wobei die Si-g-PO-Harzzusammensetzung 0,1 Gew.-% bis 4,5 Gew.-% mikronisiertes Kieselgel beinhaltet.

10. Photovoltaikmodul gemäß einem der Ansprüche 8-9, wobei das mikronisierte Kieselgel ein spezifisches Porenvolumen von 0,4 ml/g bis 1,8 ml/g aufweist, wobei das spezifische Porenvolumen unter Verwendung eines ASAP 2100-Stickstoffadsorptionsmessgeräts von Micromeritics bestimmt wird.

11. Photovoltaikmodul gemäß einem der Ansprüche 8-9, wobei das mikronisierte Kieselgel ein oberflächenmodifiziertes mikronisiertes Kieselgel ist.

12. Photovoltaikmodul gemäß einem der Ansprüche 8-11, wobei die obere Verkapselungsschicht (B) in direktem Kontakt mit der Photovoltaikzelle steht.

13. Photovoltaikmodul gemäß einem der Ansprüche 8-12, ferner beinhaltend eine vordere Verkapselungsschicht in direktem Kontakt mit der Photovoltaikzelle, wobei die vordere Verkapselungsschicht aus der silangepfropften Polyolefin(Si-g-PO)-Harzzusammensetzung aufgebaut ist, beinhaltend ein Si-g-PO und, bezogen auf das Gesamtgewicht der Si-g-PO-Harzzusammensetzung, zu 0,1 Gew.-% bis weniger als 5,0 Gew.-% ein mikronisiertes Kieselgel.

14. Photovoltaikmodul gemäß einem der Ansprüche 8-13, wobei die untere Schicht (A) ein Material mit einer Schmelztemperatur von mehr als 125 °C beinhaltet und das Material ausgewählt ist aus der Gruppe, bestehend aus Polypropylen, hochdichtem Polyethylen (HDPE), Polyamid und Kombinationen davon.

15. Ein Photovoltaikmodul, beinhaltend:
eine Photovoltaikzelle; und
eine Schicht, aufgebaut aus einer Folie, beinhaltend (i) ein oder mehrere Polyolefine, mindestens ein Alkoxysilan und mindestens ein Peroxid und (ii), bezogen auf das Gesamtgewicht der Si-g-PO-Harzzusammensetzung, zu mehr als 0 Gew.-% bis weniger als 5,0 Gew.-% ein mikronisiertes Kieselgel, wobei das mikronisierte Kieselgel ein synthetisches amorphes Siliciumdioxid ist, das (a) eine Primärpartikelgröße von 1 µm bis weniger als 10 µm und (b) eine Aggregatpartikelgröße von mehr als 1 µm bis 20 µm aufweist; und
die Folie nach Altern der Folie bei 40 °C und 0 % relativer Luftfeuchtigkeit für 60 Tage eine Glashaftung von mehr als oder gleich 15 N/mm aufweist, wie in Übereinstimmung mit ASTM F88/88M-09 gemessen.

## Revendications

1. Un module photovoltaïque comprenant :
une cellule photovoltaïque ; et
une couche composée d'un film comprenant une composition de résine de polyoléfine greffée par un silane (Si-g-PO) comprenant (i) une ou plusieurs polyoléfines greffées par un silane et (ii) de plus de 0 % en poids à moins de 5,0 % en poids d'un gel de silice micronisée, rapporté au poids total de la composition de résine de Si-g-PO ;
dans lequel le gel de silice micronisée est une silice amorphe synthétique qui a (a) une taille de particule primaire allant de 1 µm à moins de 10 µm et (b) une taille de particule agglomérée allant de plus de 1 µm à 20 µm ; et
le film a une adhésion sur verre supérieure ou égale à 15 N/mm après vieillissement du film à 40 °C et 0 % d'humidité relative pendant 60 jours telle que mesurée conformément à l'ASTM F88/88M-09.

2. Le module photovoltaïque de la revendication 1 dans lequel la composition de résine de Si-g-PO comprend de 0,1 % en poids à 4,5 % en poids du gel de silice micronisée.

3. Le module photovoltaïque de n'importe lesquelles des revendications 1 à 2 dans lequel le gel de silice micronisée a un volume de pore spécifique allant de 0,4 ml/g à 1,8 ml/g, dans lequel le volume de pore spécifique est déterminé à l'aide de l'appareil de mesure par adsorption d'azote ASAP 2100 de chez Micromeritics.

4. Le module photovoltaïque de n'importe lesquelles des revendications 1 à 3 dans lequel le gel de silice micronisée est un gel de silice micronisée modifié en surface.

5. Le module photovoltaïque de n'importe lesquelles des revendications 1 à 4, dans lequel la couche est une couche d'agent d'encapsulation avant en contact direct avec la cellule photovoltaïque.

6. Le module photovoltaïque de n'importe lesquelles des revendications 1 à 4 dans lequel la couche de film est une couche d'agent d'encapsulation arrière en contact direct avec la cellule photovoltaïque.

7. Le module photovoltaïque de n'importe lesquelles des revendications 1 à 4 comprenant une couche d'agent d'encapsulation avant comprenant la composition de résine de Si-g-PO et une couche d'agent d'encapsulation arrière comprenant la composition de résine de Si-g-PO.

8. Un module photovoltaïque comprenant :
une cellule photovoltaïque ; et
un composite d'agent d'encapsulation arrière (CAEA) comprenant une couche d'agent d'encapsulation supérieure (B),
une couche inférieure (A) et
une couche de liaison (C) entre la couche (B) et la couche (A) ;
la couche d'agent d'encapsulation supérieure (B) comprend une composition de résine de polyoléfine greffée par un silane (Si-g-PO) comprenant (i) une ou plusieurs polyoléfines greffées par un silane et (ii) de plus de 0 % en poids à moins de 5,0 % en poids d'un gel de silice micronisée, rapporté au poids total de la composition de résine de Si-g-PO ;
dans lequel le gel de silice micronisée est une silice amorphe synthétique qui a (a) une taille de particule primaire allant de 1 µm à moins de 10 µm et (b) une taille de particule agglomérée allant de plus de 1 µm à 20 µm ; et
le CAEA a une adhésion sur verre supérieure ou égale à 4 N/mm après vieillissement du film à 40 °C et 0 % d'humidité relative pendant 60 jours telle que mesurée conformément à l'ASTM F88/88M-09.

9. Le module photovoltaïque de la revendication 8 dans lequel la composition de résine de Si-g-PO comprend de 0,1 % en poids à 4,5 % en poids de gel de silice micronisée.

10. Le module photovoltaïque de n'importe lesquelles des revendications 8 à 9 dans lequel le gel de silice micronisée a un volume de pore spécifique allant de 0,4 ml/g à 1,8 ml/g, dans lequel le volume de pore spécifique est déterminé à l'aide de l'appareil de mesure par adsorption d'azote ASAP 2100 de Micromeritics.

11. Le module photovoltaïque de n'importe lesquelles des revendications 8 à 9 dans lequel le gel de silice micronisée est un gel de silice micronisée modifié en surface.

12. Le module photovoltaïque de n'importe lesquelles des revendications 8 à 11 dans lequel la couche d'agent d'encapsulation supérieure (B) est en contact direct avec la cellule photovoltaïque.

13. Le module photovoltaïque de n'importe lesquelles des revendications 8 à 12, comprenant en outre une couche d'agent d'encapsulation avant en contact direct avec la cellule photovoltaïque, la couche d'agent d'encapsulation avant composée de la composition de résine de polyoléfine greffée par un silane (Si-g-PO) comprenant une Si-g-PO et de 0,1 % en poids à moins de 5,0 % en poids d'un gel de silice micronisée, rapporté au poids total de la composition de résine de Si-g-PO.

14. Le module photovoltaïque de n'importe lesquelles des revendications 8 à 13, dans lequel la couche inférieure (A) comprend un matériau avec une température de fusion supérieure à 125 °C et le matériau est sélectionné dans le groupe constitué du polypropylène, du polyéthylène haute densité (PEHD), de polyamide, et de combinaisons de ceux-ci.

15. Un module photovoltaïque comprenant :
une cellule photovoltaïque ; et
une couche composée d'un film comprenant (i) une ou plusieurs polyoléfines, au moins un alcoxysilane, et au moins un peroxyde et (ii) de plus de 0 % en poids à moins de 5,0 % en poids d'un gel de silice micronisée, rapporté au poids total de la composition de résine de Si-g-PO, dans lequel le gel de silice micronisée est une silice amorphe synthétique qui a (a) une taille de particule primaire allant de 1 µm à moins de 10 µm et (b) une taille de particule agglomérée allant de plus de 1 µm à 20 µm ; et
le film a une adhésion sur verre supérieure ou égale à 15 N/mm après vieillissement du film à 40 °C et 0 % d'humidité relative pendant 60 jours telle que mesurée conformément à l'ASTM F88/88M-09.
